# EUROPÄISCHE PATENTSCHRIFT

(11) **EP 4 356 619 B1**
(45) Veröffentlichungstag und Bekanntmachung des Hinweises auf die Patenterteilung: **30.07.2025**
(21) Anmeldenummer: 22737767.8
(22) Anmeldetag: 17.06.2022
(51) Int. Cl.: H04R 1/08, H04R 1/28

(54) **INTERPOSER ZUR DÄMPFUNG VON MEMS-MIKROFONEN**
INTERPOSER FOR DAMPING MEMS MICROPHONES
INTERPOSEUR DESTINÉ À L'AMORTISSEMENT DES MICROPHONES MEMS

(30) Priorität: 18.06.2021 EP 21180252
(43) Veröffentlichungstag der Anmeldung: 24.04.2024
(73) Patentinhaber: Hahn-Schickard-Gesellschaft für angewandte Forschung e. V., 70569 Stuttgart (DE)
(72) Erfinder: BITTNER, Achim, 74080 Heilbronn (DE); DEHÉ, Alfons, 72770 Reutlingen (DE)
(74) Vertreter: Hertin und Partner Rechts- und Patentanwälte PartG mbB
(86) Internationale Anmeldenummer: PCT/EP2022/066577
(87) Internationale Veröffentlichungsnummer: WO 2022/263640

(56) Entgegenhaltungen:
- DE-A1- 102019 124 236
- US-A1- 2019 335 262
- US-A1- 2020 107 096

## Beschreibung

In einem ersten Aspekt betrifft die Erfindung ein System umfassend ein MEMS-Mikrofon umfassend eine Schalleintrittsöffnung, eine schwingfähige Mikrofonmembran und eine elektronische Schaltung, wobei bei einer Anregung der Mikrofonmembran durch Schallwellen, welche durch die Schalleintrittsöffnung treten, durch Schwingungen der Mikrofonmembran ein von den Schallwellen abhängiges elektrisches Signal erzeugt wird. Ein Dämpfungselement zur Reduktion eines an der Mikrofonmembran wirkenden Schalldruckpegels der Schallwellen wird vor der Schalleintrittsöffnung angebracht, wobei das Dämpfungselement eine elastische und schwingfähige Dämpfungsmembran umfasst und wobei das **Dämpfungselement** zusätzlich zur Mikrofonmembran durch die Schallwellen zu Schwingungen angeregt wird, sodass eine Schallenergie der Schallwellen zwischen der Dämpfungsmembran und der Mikrofonmembran aufgeteilt wird. Hierdurch wird es insbesondere ermöglicht, den Messbereich des MEMS-Mikrofons verzerrungsfrei auf hohe Schalldruckpegel zu erweitern, welche mit den im Stand der Technik bekannten MEMS-Mikrofonen bisher nicht messbar waren.

In einem weiteren Aspekt betrifft die Erfindung die Verwendung des erfindungsgemäßen Systems für Aeroakustikmessungen, vorzugsweise zur Messung von Schalldruckwellen an Oberflächen eines Fahrzeugbauteiles.

### Hintergrund und Stand der Technik

Für die Herstellung kompakter, mechanisch-elektronischer Vorrichtungen wird heute auf vielen Anwendungsgebieten auf die Mikrosystemtechnik zurückgegriffen. Die so herstellbaren Mikrosysteme (engl. *microelectromechanical system,* kurz MEMS) sind sehr kompakt (Mikrometerbereich) bei gleichzeitig hervorragender Funktionalität und immer geringeren Herstellungskosten.

Insbesondere sind im Stand der Technik Mikrofone bekannt, die auf der MEMS-Technologie beruhen, sogenannte MEMS-Mikrofone. Ein MEMS-Mikrofon umfasst eine schwingfähige Mikrofonmembran, die zur Aufnahme von Druckwellen eines Fluids eingerichtet ist. Bei dem Fluid kann es sich sowohl um ein gasförmiges als auch um ein flüssiges Fluid handeln, bevorzugt handelt es sich um Schalldruckwellen. Ein MEMS-Mikrofon wandelt bevorzugt Druckwellen in elektrische Signale um.

MEMS-Mikrofone zeichnen sich durch ihre einfache und kompakte Bauweise aus. Daher lassen sie sich besonders einfach zu Arrays anordnen, was für Schallmessungen mit einer Richtcharakteristik wichtig ist. Darüber hinaus können sie über verbreitete, weitreichend automatisierte Prozesse der Halbleitertechnik hergestellt werden.

Die Mehrheit der MEMS-Mikrofone sind für Audioanwendungen konzipiert, d.h. für Telefone und/oder Hörgeräte. Diese Anwendungen sind zumeist durch eine Bandbreite von weniger als 20 kHz und ein Schalldruckpegel von weniger als ca. 120 dB gekennzeichnet.

Im Stand der Technik gibt es auch Ansätze, MEMS-Mikrofone für aeroakustische Anwendungen zu konzipieren. Die Aeroakustik beschäftigt sich mit der Entstehung und Ausbreitung aerodynamisch erzeugter Geräusche und deren Minderung. Die Bedeutung der Aeroakustik hat in der Luftfahrtindustrie und in der Fahrzeugindustrie in den letzten Jahren stark zugenommen. In der Fahrzeugakustik ist dieses durch das wachsende Komfortbewusstsein der Kunden begründet.

MEMS-Mikrofone für Audioanwendungen sind allerdings für die Aeroakustik ungeeignet, da die Aeroakustik andere Anforderungen hinsichtlich der Schallgrößen aufweist.

Der Schalldruckpegel beispielsweise in der Nähe eines Düsentriebwerks kann sehr hoch sein. Daher sollte ein aeroakustisches MEMS-Mikrofon in der Lage sein, einen verzerrungsfreien Betrieb bis zu 160 dB oder mehr zu ermöglichen. Die FAA (Federal Aviation Administration, Bundesluftfahrtbehörde der USA) verlangt für die Zulassung von Verkehrsflugzeugen einen Frequenzbereich über 45 Hz < f ≤ 11,2 kHz. Aeroakustische Messungen von Flugzeugen und deren Komponenten werden jedoch häufig an maßstabsgetreuen Modellen durchgeführt, sodass der interessierende Frequenzbereich entsprechend hochskaliert wird. Zum Beispiel reicht der Frequenzbereich für ein Modell im Maßstab 1:8 bis zu 89,6 kHz. Daher muss die Bandbreite eines aeroakustischen MEMS-Mikrofons bis zu 90 kHz betragen, um für den Modellversuch geeignet zu sein (vgl. für diese Angaben David T. et al. (2007) I. Introduction).

Im Stand der Technik gibt es verschiedene Ansätze für ein MEMS-Mikrofon, welches für aeroakustische Messungen eingesetzt werden kann.

Martin et al. (2007) schlägt vor, zwei zusätzliche Rückplatten zwischen der Mikrofonmembran anzubringen. Dazu wird beim entsprechenden Herstellungsverfahren zunächst eine untere Rückplatte auf einen Wafer beschichtet. Die untere Rückplatte befindet sich unterhalb der Mikrofonmembran. Nach Anbringen der Mikrofonmembran wird eine obere Rückplatte oberhalb der Mikrofonmembran aufgetragen. Die beiden Rückplatten weisen perforierte Löcher auf. Durch die Löcher gelangt der Schall auf die Mikrofonmembran, um diese zum Auslenken zu bringen. Zudem haben sie die Funktion, die Dämpfung in den Zwischenräumen zwischen der Mikrofonmembran und den beiden Rückplatten zu reduzieren. Sowohl die Rückplatten als auch die Mikrofonmembran umfassen Polysilizium. Das MEMS-Mikrofon kann Schalldruckpegel bis zu 164 dB (mit einer Referenz auf 20 µV/Pa) messen. Eine Messung von höheren Schalldruckpegeln wird nicht offenbart.

Sheplak et al. (1999) offenbart ein piezoresistives MEMS-Mikrofon umfassend eine dünne Mikrofonmembran, die bei Schalldruck eine mechanische Biegespannung aufbaut. Die mechanische Spannung wird anhand einer elektrischen Widerstandsänderung einer auf der Membran liegenden Struktur aus piezoresistivem Material gemessen. Die Piezowiderstände werden in einer Wheatstoneschen Brückenkonfiguration auf der Mikrofonmembran platziert. Das MEMS-Mikrofon kann einen Schalldruckpegel bis zu 155 dB messen.

Horowitz et al. (2007) offenbart ein piezoelektrisches MEMS-Mikrofon, welches für aeroakustische Messungen geeignet ist. Hierbei erzeugt die mechanische Spannung einer ausgelenkten Membran bei Schallanregung an einer Sandwichstruktur aus zwei Elektroden und einer piezoelektrischen Schicht eine elektrische Spannung. Allerdings ist die erreichte Sensitivität verhältnismäßig gering und das Mikrofon kann maximal einen Schalldruckpegel bis zu 169 dB messen.

DE 10 2019 124236 A1 offenbart eine Schallmessvorrichtung mit einem an einer Platine montierten akustischen MEMS-Sensor, wobei zusätzlich zu einer durch Schall auslenkbare Sensormembran des MEMS-Sensors hinter einem in der Platine ausgebildeten Schallloch eine Dämmmembran den Lochquerschnitt des Schalllochs überspannt und am Rand starr abgestützt ist. Durch Bereitstellung der Dämmmembran soll der Schallpegel des durch das Schallloch hindurchtretenden Schalls reduziert werden, um Messverfahren mit hohen Maximalschallpegeln zu ermöglichen. Bei geeigneter elastischer Ausbildung der Dämmmembran soll eine lineare Reduktion des Schalldruckpegels bewirkt werden. Konkrete Werte hinsichtlich der Reduktion des Schalldruckpegels werden nicht offenbart.

Im Stand der Technik sind auch weitere MEMS-Mikrofone bekannt, welche eine zusätzliche Membran aufweisen, die jedoch nicht zur Reduktion von Schalldruckpegeln ausgelegt ist.

So wird in der US 2019/335262 A1 eine Mikrofonanordnung umfassend einen MEMS-Transducer offenbart, wobei der MEMS-Transdrucer eine elastomerische Membran aufweist. Die elastomerische Membran dient dem Schutz vor Verunreinigungen und soll einen vernachlässigbaren Einfluss auf die akustische Leistung haben. Insbesondere soll die elastomerische Membran akustisch transparent ausgebildet sein und zu einer Reduktion des SNR (englisch: signal-to-noise ratio, deutsch: Signal-Rausch-Verhältnis) von weniger als 1 % führen.

Die US 2020/107096 A1 offenbart eine Mikrofonanordnung umfassend eine Portmembran zum Schutz vor einem Eintritt von Flüssigkeiten. Die Portmembran soll insbesondere gaspermeabel sein, um durchlässig bzw. transparent für akustische Energie zu sein. Weiterhin soll die akustische Energie mit nur geringer oder keiner Dämpfung übertragen werden können. Insbesondere sollten höchstens Verluste von Schallleistungen von etwa 3,5 dB im Kontext der Offenbarung der US 2020/107096 A1 akzeptabel sein. Zusätzlich zur Portmembran kann die Mikrofonanordnung ein akustisches Gitter aufweisen, welches als ein Drahtgewebe beschrieben wird. Das Drahtgewebe kann entweder akustisch transparent ausgebildet sein oder eine frequenzabhängige Dämpfung erzielen, wodurch das akustische Signal jedoch verzerrt werden kann.

Für bestimmte aeroakustische Messungen werden auch MEMS-Mikrofone benötigt, die Schalldruckpegel bis 180 dB messen können. Für solch hohen Schalldruckpegel sind die aus dem Stand der Technik bekannten MEMS-Mikrofone nicht ausgelegt.

Mikrofone, die solch hohe Schalldruckpegel messen können, haben eine größere Bauform. Größere Bauformen haben allerdings den Nachteil, dass sie die Luftströmung selbst durch ihre Dimension beeinflussen. Eine Beeinflussung der Strömung durch das Mikrofon selbst gilt es aber für genaue Messungen zu vermeiden. Insbesondere sind bei den Messungen kleine laterale Auflösungen des Strömungsverhaltens nicht mehr möglich, wenn das Mikrofon eine zu große Bauweise aufweist. Zudem eignen sich große Mikrofone nicht, um an technischen Oberflächen, wie beispielsweise einer Flugzeugoberfläche oder an Automobilbauteilen, angebracht zu werden. Darüber hinaus sind Mikrofone, die so hohe Schalldruckpegel messen können, welche in der Aeroakustik von Bedeutung sind, nur zu sehr hohen Kosten zu erwerben.

MEMS-Mikrofone, die sehr hohe, insbesondere in der Aeroakustik geeignete, Schalldruckpegel messen können, mit gleichzeitig hoher lateraler Auflösung von kleinsten Verwirbelungen der Luftströmung und zudem in ihrer Herstellung kostengünstig sind, sind aus dem Stand der Technik nicht bekannt.

### Aufgabe der Erfindung

Aufgabe der vorliegenden Erfindung war es, die Nachteile des Standes der Technik zu beseitigen und ein verbessertes System bereitzustellen, welches sehr hohe Schalldruckpegel messen kann, die Messergebnisse hochaufgelöst sind und es zu keinen Verzerrungen der Messergebnisse kommt. Insbesondere war es eine Aufgabe, Systeme zu bieten, die für aeroakustische Messungen geeignet sind. Zudem sollten die Systeme einfach und kostengünstig hergestellt werden können.

### Zusammenfassung der Erfindung

Die erfindungsgemäße Aufgabe wird gelöst durch die Merkmale der unabhängigen Ansprüche. Vorteilhafte Ausgestaltungen der Erfindung sind in den abhängigen Ansprüchen beschrieben.

In einer bevorzugten Ausführungsform betrifft die Erfindung ein System umfassend
a) ein MEMS-Mikrofon umfassend eine Schalleintrittsöffnung, eine schwingfähige Mikrofonmembran und eine elektronische Schaltung, wobei bei einer Anregung der Mikrofonmembran zu Schwingungen durch Schallwellen, welche durch die Schalleintrittsöffnung treten, ein von den Schallwellen abhängiges elektrisches Signal erzeugt wird und
b) ein Dämpfungselement zur Reduktion eines an der Mikrofonmembran wirkenden Schalldruckpegels der Schallwellen
dadurch gekennzeichnet, dass das Dämpfungselement eine elastische und schwingfähige Dämpfungsmembran umfasst, welche vor der Schalleintrittsöffnung angebracht vorliegt.

Die Dämpfungsmembran wird zusätzlich zur Mikrofonmembran durch die Schallwellen zu Schwingungen angeregt, sodass eine Schallenergie der Schallwellen zwischen der Dämpfungsmembran und der Mikrofonmembran aufgeteilt wird.

Das erfindungsgemäße System hat sich in vielerlei Aspekten als vorteilhaft erwiesen, die im Folgenden näher ausgeführt werden.

Vorteilhafterweise ist das erfindungsgemäße System dazu in der Lage, besonders hohe Schalldruckpegel zu messen. Insbesondere kann das System Schalldruckpegel bis zu 200 dB messen, was mit den im Stand der Technik bekannten MEMS-Mikrofone nicht möglich ist.

Technisch begründet sich dies damit, dass die Schallenergie zwischen der Mikrofonmembran und dem Dämpfungselement, welches eine elastische und schwingfähige Dämpfungsmembran umfasst, aufgeteilt wird. Schallwellen gehen mit Wechselbewegungen von Teilchen des Mediums einher, in dem sich der Schall ausbreitet. Gleichzeitig kommt es zur abwechselnden Verdichtung und Verdünnung von Teilen des Mediums. Die Energie, die der Schall besitzt, kann sich mithin als Summe von kinetischer und potenzieller Energie darstellen. Beim Eintritt des Schalls trifft der Schall zunächst auf das Dämpfungselement, welches eine elastische und schwingfähige Dämpfungsmembran umfasst, und überträgt einen Teil seiner Energie darauf. Diese Energieübertragung kann im Kontext der Erfindung als eine erste Energieübertragung bezeichnet werden. Nach der ersten Energieübertragung durch den Schall gelangt der Schall durch die Schalleintrittsöffnung auf die Mikrofonmembran, sodass die Mikrofonmembran in Schwingungen versetzt wird. Die Energieübertragung des Schalls auf die Mikrofonmembran des MEMS-Mikrofons kann als zweite Energieübertragung im Kontext der Erfindung aufgefasst werden.

Die Schwingungen der Mikrofonmembran stellen bevorzugt das eigentlich gemessene Signal dar, welches durch die Übertragung der Schwingungen auf eine elektrische Schaltung entsteht, die mit dem MEMS-Mikrofon verbunden ist.

Insbesondere erfolgt die Verteilung der Schallenergie auf das Dämpfungselement und auf die Mikrofonmembran weitestgehend verlustfrei und verzerrungsfrei. Dies begründet sich durch die Elastizität der Dämpfungsmembran. Die Elastizität der Dämpfungsmembran bezeichnet die Eigenschaft, dass diese durch Krafteinwirkung seine Form verändert und bei Wegfall der einwirkenden Kraft in die Ursprungsform zurückkehrt, ähnlich zu einer Feder. Tatsächlich kommt die Schwingung der Dämpfungsmembran dadurch zustande, dass diese elastisch ist und eine Schallwelle eine räumliche Ausbreitung einer mechanischen Schwingung durch Schwingungen eines Fluids, insbesondere von Luft, im Raum darstellt. Mit der sich ausbreitenden Schwingung erfolgt eine Energieübertragung, zunächst auf die Dämpfungsmembran und anschließend auf die Mikrofonmembran. Dabei ist die Dämpfungsmembran elastisch und insbesondere nicht plastisch, d. h. sie verändert ihre Form bei der Wirkung einer Schallwelle und gelangt in ihren Ausgangszustand zurück.

Bevorzugt weisen das Dämpfungselement und die Mikrofonmembran dasselbe Schwingungsverhalten auf, jedoch haben die Schwingungen des Dämpfungselements eine geringere Amplitude als die der Mikrofonmembran. Bemerkenswert ist in dem Zusammenhang, dass die volle Bandbreite des gemessenen Schalls erhalten bleibt und insbesondere kein Anteil der Bandbreite verloren geht. Durch Bereitstellung des elastischen Dämpfungsmembran wird das Schwingungsverhalten der Mikrofonmembran qualitativ nicht verändert. Stattdessen erfolgt durch die Teilung der Schallenergie eine verzerrungsfreie Reduktion der Amplitude der schwingenden Mikrofonmembran über das gesamte Frequenzspektrum. Eine frequenzabhängige Dämpfung, welche beispielsweise an höheren Frequenzen ausgeprägter ist als an niedrigeren Frequenzen, wird vermieden. Zudem bleibt auch das Signal-Rausch-Verhältnis (engl. signal-to-noise-ratio, SNR-Verhältnis oder SNR-Ratio) eines gemessenen akustischen Signals durch die Aufteilung der Schallenergie des einfallenden Schalls auf das Dämpfungselement und Mikrofonmembran bestehen.

Die Wirkungsweise des erfindungsgemäßen Systems lässt sich zu einem gewissen Grad anhand einer Analogie zu einem Pegelschieber aus der Elektrotechnik erläutern.

Ein Pegelschieber (auch Pegelumsetzer oder Pegelwandler genannt, engl. level shifter) bezeichnet in der Elektrotechnik eine diskrete oder integrierte elektronische Schaltung, welche die Signalpegel - meistens Spannungspegel - einer Bauteilkomponente zu einer weiteren Bauteilkomponente anpasst, einem Sender und einem Empfänger. Da nicht alle Baugruppen mit denselben Spannungspegeln arbeiten, ist es für eine Kommunikation dieser Baugruppen untereinander erforderlich, die Signalpegel der Informationssignale zu adaptieren (anzupassen). Diese Anpassung kann je nach Anforderung durch eine aktive oder passive elektronische Schaltung geschehen. Bei analogen Schaltungen werden Signalpegel des Senders meist durch Verstärker an die des Empfängers angepasst. Beispielsweise wird das Signal eines Mikrofons durch einen Mikrofonvorverstärker an den Eingangssignalpegelbereich des AUX-Eingangs eines Verstärkers adaptiert.

Es gibt jedoch Anwendungen, bei denen ein einfaches Verstärken oder Abschwächen des Informationssignals nicht ausreicht und das Signal zusätzlich im Spannungsbereich verschoben werden muss. Soll beispielsweise ein Audiosignal mit einem typischen Spannungsbereich von -100 mV bis 100 mV digitalisiert werden, ist es nicht nur nötig dieses Signal zu verstärken, sondern auch durch Addition einer Offsetspannung zu verschieben, wofür sich beispielsweise die Schaltung des Subtrahierverstärkers anbietet.

In Analogie wurde von den Erfindern erkannt, dass sich die Mikrofonmembran eines MEMS-Mikrofons nicht eignet, um die hohen Schalldruckpegel, welche insbesondere in der Aeroakustik erscheinen, zu detektieren. Durch das Anbringen des Dämpfungselements als elastische, schwingfähige Membran, kann der hohe Schalldruckpegel vorteilhaft verschoben werden, sodass die Mikrofonmembran den verschobenen Bereich messen kann. Dies erfolgt durch eine Aufnahme eines Anteils des hohen Schalldruckpegels, um einen weiteren Anteil des Schalldruckpegels für die Mikrofonmembran detektierbar zu gestalten. Eine Verzerrung des Signals, beispielsweise durch eine frequenzabhängige Dämpfung, erfolgt nicht.

Ein weiteres physikalisches Analogon zur Verdeutlichung der erfindungsgemäßen Idee kann in dem mechanischen Wirkungsprinzip einer Reihenschaltung zweier Federn gesehen werden. Bei Federn, welche in Reihe geschaltet sind, verteilt sich eine angreifende Kraft verteilt sich nicht (wie bei der Parallelschaltung), sondern wirkt durch die beiden Federn mit dem gleichen Betrag. Die Federn können bei der Reihenschaltung unterschiedliche Federkonstanten und unterschiedliche Längen haben, was entsprechende Auswirkungen auf die Gesamt-Längenänderung hat. Das Dämpfungselement und die Mikrofonmembran sind ebenso gekoppelt, sodass bei Wirkung einer Kraft durch eintreffende Schallwellen auf das Dämpfungselement auch die Mikrofonmembran durch sich nach dem Dämpfungselement ausbreiteten und unverzerrte Schallwellen zu Schwingungen angeregt wird.

Das erfindungsgemäße System kann als Instrument insbesondere vorteilhaft eingesetzt werden, um hochauflösende Messungen hinsichtlich Schallgrößen, wie hohen Schalldruckpegeln, durchzuführen, beispielsweise in einem Windkanal. Es ist auch möglich, dass das erfindungsgemäße System an Oberflächen verbaut wird, an hohe Werte von Schalldruckpegeln, beispielsweise an der Oberfläche von Komponenten eines Flugzeugs, auftreten. Auch der Einsatz des erfindungsgemäßen Systems in zur Messung der Ausbreitung von Schallwellen an anderen Oberflächen oder Fahrzeugen ist möglich. Ein durchschnittlicher Fachmann ist in der Lage, das erfindungsgemäße System in verschiedenen Bereichen anzuwenden.

Des Weiteren ist ein Vorteil des erfindungsgemäßen Systems, dass dieses nur sehr geringe Ausmaße aufweist. Insbesondere kann die laterale Ausdehnung des erfindungsgemäßen Systems geringgehalten werden. Dies ist dahingehend von Vorteil, dass das erfindungsgemäße System die umströmte Luft nicht beeinflusst. Damit werden Messergebnisse nicht verfälscht und besonders genau wiedergegeben. Insbesondere können kleinste Verwirbelungen der umströmten Luft detektiert werden, um ein genaues Strömungsverhalten des umströmten Fluids, insbesondere Luft, und/oder sehr detailliert Schallgrößen zu ermitteln. Im Besonderen wird es vorteilhafterweise ermöglicht, sehr geringe laterale Auflösungen des Schalldruckpegels zu bestimmen.

Die Miniaturisierung des erfindungsgemäßen Systems geht mit weiteren Vorteilen einher. Durch die geringe Dimension des erfindungsgemäßen Systems ergibt sich eine höhere Dichte an Systemen, die beispielsweise entlang eines Arrays ausgebildet sein können. Durch eine hohe Zahl des erfindungsgemäßen Systems bzw. an MEMS-Mikrofonen können Messergebnisse besonders präzise ermittelt werden. Zudem leidet die Messqualität durch eine hohe Anzahl nicht, wenn aus beliebigen Gründen einzelne Systeme eines Arrays ausfallen sollten.

Durch eine Anordnung des erfindungsgemäßen Systems zu einem Array sind ebenfalls Anwendungen möglich, die beispielsweise Beamforming nutzen, um Messerwerte gezielt aus einer bestimmten Richtung zu ermitteln. Dadurch kann beispielsweise ein Schalldruckpegel aus einer gewünschten Position gerichtet und gezielt mit einer hohen Genauigkeit ermittelt werden. Aus dem Stand der Technik sind diverse Formen eines Arrays bekannt, beispielsweise eindimensionale, zweidimensionale und/oder dreidimensionale Arrays.

Es ist ein weiterer Vorteil ist es, dass erfindungsgemäß das Dämpfungselement zusammen mit einem MEMS-Mikrofon verbaut werden kann, da MEMS-Mikrofone in sehr kleinen Gehäusen verfügbar sind, die sich unter anderem uneingeschränkt für die SMT-Bestückung (engl. surfacemounting technology) eignen. Außerdem weisen MEMS-Mikrofone ausgezeichnete Temperatureigenschaften auf. Die Temperaturbeständigkeit des Systems kann insbesondere für aeroakustische Anwendungen wünschenswert sein.

Bevorzugt kann durch die Bereitstellung der Dämpfungsmembran das System ein geschlossenes System bilden, sodass beim Verbau des erfindungsgemäßen Systems an einer Oberfläche der Eintritt von unerwünschter Materie, z. B. Schmutz, Ruß und/oder Staub, in das System verhindert wird. Insbesondere werden dabei innere Komponenten des erfindungsgemäßen Systems, beispielsweise innere Komponenten des MEMS-Mikrofons, nicht beschädigt. Somit hat das Dämpfungselement nicht nur die Funktion, den Schalldruckpegel auf einen für die Mikrofonmembran messbaren Bereich unverzerrt zu verschieben, sondern stellt auch eine Schutz- und Barrierefunktion gegenüber der Umgebung dar. Weiterhin wird es ermöglicht, eine Anhaftung von Schmutz über eine Antihaftbeschichtung zu verhindern oder anhaftenden Schmutz an der Oberfläche des Systems besonders einfach zu entfernen.

Weiterhin eignet sich das erfindungsgemäße System bevorzugt auch zum Verbau an flexiblen Oberflächen, beispielsweise in dem flexiblen Leiterplatten zur Positionierung des Dämpfungselementes und des MEMS-Mikrofons verwandt werden. Damit ist das erfindungsgemäße System nicht auf feste Formen oder Strukturen von Oberflächen beschränkt und weist vorteilhaft einen hohen Einsatzbereich auf. So ist es möglich, dass System an Ecken, Kanten, Rundungen und/oder an gekrümmten und/oder verbogenen Oberflächen zu befestigen.

Darüber hinaus kann das erfindungsgemäße System durch standardisierte Prozesse der Halbleiter- und Mikrosystemtechnik hergestellt werden, sodass auf bewährte, automatisierte Verfahren der Halbleiterprozessierung zurückgegriffen und eine kostengünstige Massenherstellung umgesetzt werden kann.

Ein MEMS-Mikrofon bezeichnet bevorzugt ein Mikrofon, welches auf MEMS-Technologie basiert und dessen klangaufnehmenden Strukturen mindestens teilweise eine Dimensionierung im Mikrometerbereich (ca. 1 µm bis ca. 1000 µm) aufweisen. Die klangaufnehmenden Strukturen werden als Mikrofonmembran bezeichnet. Bevorzugt kann die Mikrofonmembran in Breite, Höhe und/oder Dicke eine Dimension im Bereich von weniger als 1000 µm aufweisen. Insbesondere ist die Mikrofonmembran schwingfähig.

Die Mikrofonmembran ist zur Aufnahme von Druckwellen des Fluids eingerichtet. Bei dem Fluid kann es sich sowohl um ein gasförmiges als auch flüssiges Fluid handeln, bevorzugt handelt es sich um Schalldruckwellen. Ein MEMS-Mikrofon wandelt mithin bevorzugt Druckwellen in elektrische Signale um. Mittels einer elektronischen Schaltung können bevorzugt die schwingfähige Membran, dessen Schwingungen beispielsweise durch piezoelektrische, piezoresistive oder kapazitive Komponenten an der Membran erzeugt und/oder ausgelesen werden. Die Mikrofonmembran ist bevorzugt hinreichend dünn, sodass sie sich unter dem Einfluss der von den Schallwellen verursachten Luftdruckänderungen durchbiegt und in ein Schwingungsverhalten übergeht. Während die Mikrofonmembran schwingt, können sich elektrische Größen ändern, wie beispielsweise die Kapazität zwischen der Membran und der Rückwand. Die Änderung einer elektrischen Größe, beispielsweise eine Kapazitätsänderung kann, von einer in dem MEMS-Mikrofon eingebauten elektrischen Schaltung, beispielsweise ein ASIC oder eine Recheneinheit, in ein elektrisches Signal umgewandelt werden. Die elektrische Schaltung misst Änderungen von derartigen elektrischen Größen, beispielsweise Spannungsänderungen, Stromänderungen oder Kapazitätsänderungen, die entstehen, wenn die Mikrofonmembran unter dem Einfluss von Schallwellen schwingt.

Die Schalleintrittsöffnung bezeichnet bevorzugt eine Öffnung des MEMS-Mikrofons, durch die Schallwellen hindurchgelangen und auf die Mikrofonmembran treffen können. Vorzugsweise befindet sich die Schalleintrittsöffnung in Fließrichtung des Fluids, insbesondere Luft, vor der Mikrofonmembran.

Die elektronische Schaltung wandelt die Schwingungen der Mikrofonmembran bevorzugt in elektrische Signale um. Dies basiert darauf, dass sich bei der Schwingung der Mikrofonmembran eine oder mehrere elektrische Größen, wie beispielsweise eine Spannung und/oder eine Kapazität, verändern. Die elektronische Schaltung umfasst dabei bevorzugt elektrische Verbindungen, beispielsweise Drähte, die mit der Mikrofonmembran kontaktiert vorliegen. Zudem kann die elektronische Schaltung einen ASIC (engl. application-specific integrated circuit, deutsch anwendungsspezifische integrierte Schaltung), eine Recheneinheit, eine integrierte Schaltung (IC), eine programmierbare logische Schaltung (PLD), ein Field Programmable Gate Array (FPGA), einen Mikroprozessor, einen Mikrocomputer, eine speicherprogrammierbare Steuerung und/oder sonstige elektronische Schaltungselemente aufweisen. Durch die Schwingungen der Mikrofonmembran wird durch die elektronische Schaltung ein von den Schallwellen und damit auch von den Amplituden der Schwingungen der Mikrofonmembran abhängiges elektrisches Signal erzeugt.

Schall bezeichnet bevorzugt eine als Welle fortschreitende mechanische Deformation in einem Medium. In einem Fluid ist Schall stets eine Longitudinalwelle, insbesondere auch in Luft. Die Begriffe "Schall" und "Schallwelle" können daher synonym verwendet werden. In Gasen wie Luft kann Schall als eine dem statischen Luftdruck überlagerte Schalldruckwelle beschrieben werden. Meistens sind bei Schallwellen die Schwankungen der Zustandsgrößen Druck und Dichte klein im Verhältnis zu ihren Ruhegrößen. Wenn im Folgenden Luft als Fluid der Schallwellen diskutiert wird, so weiß der durchschnittliche Fachmann, dass die Erläuterungen auch auf andere Fluide übertragbar sind.

Das Dämpfungselement bezeichnet bevorzugt eine Komponente des erfindungsgemäßen Systems, das bevorzugt zur Reduktion des an der Mikrofonmembran wirkenden Schalldruckpegels der Schallwellen dient. Da die Mikrofonmembran zu hohe Schalldruckpegel nicht messen kann, wird durch das Dämpfungselement der Schalldruckpegel der Schallwelle in einem für die Mikrofonmembran messbaren Bereich unverzerrt verschoben. Insbesondere bezeichnet ein unverzerrtes Verschieben, dass keine Informationen und/oder Werte des eigentlichen Schalldruckpegels verloren gehen. Bevorzugt bleibt hierbei die Bandbreite des gemessenen Signals erhalten und das Signal-Rausch-Verhältnis unverändert. Zu diesem Zweck wird die Schallenergie der Schallwelle zwischen der Mikrofonmembran und dem Dämpfungselement wie obig beschrieben verzerrungsfrei aufgeteilt. Dazu umfasst das Dämpfungselement insbesondere eine elastische schwingungsfähige Dämpfungsmembran. Diese schwingt vorzugsweise mit einem qualitativ gleichen Schwingungsverhalten wie mit der Mikrofonmembran mit, wenn eine Schallwelle auf das System trifft.

Das Anbringen des Dämpfungselements *vor* der Schalleintrittsöffnung bezeichnet bevorzugt eine Bauweise des erfindungsgemäßen Systems, bei der eine Schallwelle zunächst das Dämpfungselement trifft, bevor es die Mikrofonmembran erreicht. Daher ist aus Sicht einer einkommenden Schallwelle das Dämpfungselement bevorzugt die erste Komponente des erfindungsgemäßen Systems. Insbesondere wird durch die Schallwelle zunächst das Dämpfungselement in Schwingungen versetzt, bevor die Mikrofonmembran in Schwingungen versetzt wird. Die Schwingungen des Dämpfungselements und der Mikrofonmembran können daher phasenverschoben sein. Die Schwingungsverhalten des Dämpfungselements und der Dämpfungsmembran sind zwar vom Schwingungsverhalten im Wesentlich gleich, in der Amplitude und in der Phase jedoch verschieden.

Begriffe wie im Wesentlichen, ca. etc. beschreiben bevorzugt einen Toleranzbereich von weniger als ± 40 %, bevorzugt weniger als ± 20 %, besonders bevorzugt weniger als ± 10 %, noch stärker bevorzugt weniger als ± 5 % und insbesondere weniger als ± 1 % und umfassen insbesondere den exakten Wert. Ähnlich beschreibt bevorzugt Größen, die ungefähr gleich sind. Teilweise beschreibt bevorzugt zu mindestens 5 %, besonders bevorzugt zu mindestens 10 %, und insbesondere zu mindestens 20 %, in einigen Fällen zu mindestens 40 %.

Das erfindungsgemäße System ist dadurch gekennzeichnet, dass eine Aufteilung der Schallenergie der einfallenden Schallwellen auf die Dämpfungsmembran und die Mikrofonmembran zu einer Reduktion des an der Mikrofonmembran wirkenden Schalldruckpegels um mindestens 10 dB, bevorzugt um mindestens 20 dB, besonders bevorzugt um mindestens 30 dB führt.

Vorteilhafterweise wird es durch die Reduktion des an der Mikrofonmembran wirkenden Schalldruckpegels um die genannten Werte ermöglicht, dass besonders hohe Schalldruckpegel, wie sie insbesondere in der Aeroakustik vorkommen, beispielsweise ca. 175 dB, verzerrungsfrei gemessen werden können. Hierdurch erweitert sich der Einsatzbereich des erfindungsgemäßen Systems. Hingegen sind die im Stand der Technik bekannten MEMS-Mikrofone nicht in der Lage, so hohe Schalldruckpegel, wie z. B. bis zu 170 dB, 175 dB, 180 dB, 185 dB, 190 dB, 195 dB, 200 dB oder höher, zu messen.

Eine derartige Reduktion wird beispielsweise durch die aus der US 2019/335262 A1 und US 2020/107096 A1 offenbarten Membranen nicht ermöglicht und ist im Kontext dieser Druckschriften auch nicht erwünscht. Die Membranen der US 2019/335262 A1 und US 2020/107096 A1 dienen vielmehr einem Schutz vor Verunreinigungen, wobei eine Reduktion der Schallleistung gerade durch eine Ausgestaltung der Membran als akustisch transparent vermieden werden soll. Die generelle Möglichkeit einer Reduktion der Schalldruckpegel wird in der DE 10 2019 124236 A1 gelehrt. Es erfolgt jedoch weder eine Offenbarung der obig genannten besonders bevorzugten Werte noch der damit verbundenen Vorteile.

Es ist weiterhin ein besonderer Vorteil, dass durch das erfindungsgemäße System geringste laterale Auflösungen des Schalldruckpegels gemessen werden können. Die laterale Auflösung bezeichnet hierbei bevorzugt eine Auflösung quer zum Verlauf eines Messweges mittels Schallwellen. Das Gegenteil der lateralen Auflösung ist die axiale Auflösung entlang des Längsverlaufs des Messweges, d.h. der Strecke des Schalls. Insbesondere ist die laterale Auflösung der Abstand zweier nebeneinander gelegenen Objekte, z. B. zwei Schallquellen, die als zwei Punkte abgebildet werden können. Hierdurch wird es vorteilhafterweise ermöglicht, ein sehr genaues Bild des Schallfeldes zu erstellen, trotz hoher Schalldruckpegel.

Ein Schallfeld bezeichnet bevorzugt das Gebiet in einem elastischen Medium, insbesondere in Luft, in dem sich Schallwellen ausbreiten. Der Schalldruckpegel (engl. SPL, Sound Pressure Level) ist der dekadische Logarithmus des quadratischen Verhältnisses zwischen dem Effektivwert des gemessenen Schalldrucks und seinem in der Akustik gebräuchlichen Bezugswert von 20 µPa. Die Schallenergie bezeichnet bevorzugt die in einem Schallfeld oder einem Schallereignis enthaltene Energie, welche sich, wie weiter oben bereits erwähnt, als Summe von kinetischer und potenzieller Energie darstellen lässt. Die zugehörige logarithmische Größe ist der Schallenergiepegel. Erfindungsgemäß ist das Dämpfungselement bevorzugt ein elastischer Körper, der zu mechanischen Schwingungen angeregt wird durch die Wirkung auftreffender Schallwellen. Als mechanische Welle überträgt Schall zwar keine Materie, aber Energie. Die Schallenergie der Schallwelle wird übertragen und aufgeteilt in Schwingungsenergien des Dämpfungselements und der Mikrofonmembran.

Insbesondere im Term der kinetischen Energie der Energiebilanz befindet sich der Schalldruck. Als Schalldruck werden die Druckschwankungen des Mediums bezeichnet, insbesondere der Luft, die bei der Ausbreitung des Schalls auftreten. Hierbei ist die Angabe als Effektivwert gebräuchlich, da es sich insbesondere um ein harmonisches Phänomen handelt. Der gemessene Effektivwert des Schalldrucks geht in den in dB (Dezibel) angegebenen Schalldruckpegel ein. Somit wird durch die Aufteilung der Schallenergie zwischen Dämpfungselement bzw. Dämpfungsmembran und Mikrofonmembran auch der Schalldruckpegel herabgesetzt, sodass vorteilhafterweise sehr hohe Schalldruckpegel gemessen werden können. Insbesondere wird hierbei der Schalldruckpegel nicht verzerrt und das Signal-Rausch-Verhältnis bleibt unverändert.

In einer weiteren bevorzugten Ausführungsform ist das erfindungsgemäße System dadurch gekennzeichnet, dass das MEMS-Mikrofon ein Gehäuse aufweist, in welchem die Schalleintrittsöffnung eingebracht vorliegt.

Das Gehäuse des MEMS-Mikrofons umfasst bevorzugt eine feste und insbesondere schützende Umhüllung des MEMS-Mikrofons. Insbesondere dient das Gehäuse vorteilhafterweise dem Schutz der Komponenten des MEMS-Mikrofons, beispielsweise vor Fremdmaterial und/oder Beschädigung. Das Gehäuse kann jedoch auch weitere Funktionen aufweisen. Beispielsweise kann das Gehäuse neben der Schutzfunktion auch eine Trägerfunktion haben. Vorteilhafterweise verringert der Verzicht auf eine zusätzliche tragende Struktur das Gewicht, die Anzahl der Baukomponenten, den Montageaufwand und damit auch die Kosten für die Herstellung.

Am Gehäuse befinden sich bevorzugt Befestigungsbereiche, um das MEMS-Mikrofon mit dem Gehäuse zu verbinden. Dabei können übliche im Stand der Technik bekannte Verfahren eingesetzt werden, wie beispielsweise löten und/oder kleben. Solche Befestigungsmöglichkeiten und Verfahren dazu liegen im Kenntnisbereich des durchschnittlichen Fachmanns und sollen nicht näher diskutiert werden.

Vorzugsweise befindet sich die Schalleintrittsöffnung am Gehäuse über der Mikrofonmembran. Es kann auch bevorzugt sein, dass sich die Schalleintrittsöffnung nicht direkt über der Mikrofonmembran befindet. Durch die Schalleintrittsöffnung gelangt der Schall zur Mikrofonmembran, die durch die Schallwellen in Schwingungen versetzt wird. Dazu wird durch die elektronische Schaltung ein Signal erzeugt, welches auf verschiedene Schallgrößen, wie Schallauslenkung, Schalldruck, Schalldruckpegel, Schallenergiedichte, Schallenergie, Schallfluss, Schallgeschwindigkeit, Schallimpedanz, Schallintensität, Schallleistung, Schallschnelle, Schallamplitude und/oder Schallstrahlungsdruck schließen lässt.

In einer weiteren bevorzugten Ausführungsform ist das erfindungsgemäße System dadurch gekennzeichnet, dass die Dämpfungsmembran aus einem elastischen Material gebildet wird, vorzugsweise ausgewählt aus einer Gruppe umfassend monokristallines Silizium, Polysilizium, Siliziumdioxid, Siliziumnitrid, Siliziumcarbid, Siliziumgermanium, Siliziumnitrid, Nitrid, Germanium, Kohlenstoff, Galliumarsenid, Galliumnitrid, Indiumphosphid, Glas und/oder einem Metall. Bevorzugt handelt es sich um möglichst ideal elastische Materialien, bei denen in Funktion als Dämpfungsmembran keine plastischen Verformungen auftreten. In weiteren bevorzugten Ausführungsformen kann die Dämpfungsmembran ein Material umfassend einen Faser-Kunststoff-Verbund umfassen.

In einer weiteren bevorzugten Ausführungsform ist das erfindungsgemäße System dadurch gekennzeichnet, dass die Dämpfungsmembran eine Dicke von 50 nm bis 500 µm, bevorzugt 100 nm bis 200 µm, besonders bevorzugt 1 µm bis 50 µm aufweist

Die genannten Materialien und Dimensionierungen haben sich als besonders vorteilhaft erwiesen, um eine schwingungsfähige Dämpfungsmembran bereitzustellen. Das liegt daran, dass die genannten Materialien, insbesondere bei den genannten Dicken, für das erfindungsgemäße System eine geeignete Elastizität gezeigt haben. Dabei führt die Dämpfungsmembran beim Auftreffen von Schallwellen Schwingungen durch. Insbesondere verformen sich die genannten Materialien unter der Wirkung von Schallwellen elastisch und nicht plastisch. Die Dämpfungsmembran wird daher insbesondere reversibel verformt. Wirkt auf die Dämpfungsmembran eine Schallwelle ein, so wird die Gleichgewichtslage gestört und die Dämpfungsmembran verformt. Da die Schallwelle eine Fortpflanzung von Schwingungen darstellt, werden diese an die Dämpfungsmembran übertragen und somit ebenso in Schwingungen versetzt.

Dabei entspricht das Schwingungsverhalten der Dämpfungsmembran vorzugsweise im Wesentlichen dem Schwingungsverhalten der Mikrofonmembran. Ein Unterschied besteht hinsichtlich des Schwingungsverhalten in Amplitude und Phase, die Gestalt bzw. Form der Schwingung ist vorzugsweise im Wesentlichen gleich. Vorteilhafterweise wird somit der Schalldruckpegel auf messbare Werte verschoben, sodass auch besonders hohe Schalldruckpegel durch das erfindungsgemäße System detektiert werden können. Dabei ist es besonders vorteilhaft, dass Werte der Bandbreite des gemessenen Schallereignisses nicht verloren gehen. Zudem bleibt das Signal-Rausch-Verhältnis gleich. Das Messsignal wird vorteilhafterweise derart unverzerrt verschoben, dass hohe Schalldruckpegel, wie beispielsweise von 175 dB, unverzerrt gemessen werden können.

Des Weiteren ist der Einsatz der genannten Materialien als Dämpfungsmembran dahingehend besonders vorteilhaft, dass sie sich sehr leicht über im Stand der Technik bekannte und bewährte Verfahren bearbeiten lassen. Neben der bereits erwähnten geeigneten Elastizität sind die genannten Materialien gleichzeitig robust und stabil, um trotz der hohen Schalldruckpegel nicht zu zerreißen. Zudem sind sie vorteilhafterweise in ihrer Beschaffung und Weiterverarbeitung kostengünstig.

Weiterhin sind die genannten Materialien und Werte für den Herstellungsprozess des erfindungsgemäßen Systems vorteilhaft, da sich für eine Massenfertigung eignen. Insbesondere können standardisierte Herstellungstechniken für eine Beschichtung und/oder Bearbeitung zur Bildung der Dämpfungsmembran zum Einsatz kommen.

In einer weiteren bevorzugten Ausführungsform ist das erfindungsgemäße System dadurch gekennzeichnet, dass die Dämpfungsmembran sich mindestens über die Schalleintrittsöffnung erstreckt und/oder die Dämpfungsmembran eine laterale Ausdehnung von 100 µm bis 2000 µm, vorzugsweise 200 µm bis 1000 µm, aufweist.

Die Dämpfungsmembran deckt somit mindestens die Schalleintrittsöffnung ab, kann sich auch über die Schalleintrittsöffnung hinaus oder über eine gesamte Oberfläche über der Schalleintrittsöffnung erstrecken.

Die Erstreckung der Dämpfungsmembran über die Schalleintrittsöffnung des MEMS-Mikrofons liefert zum einen die beschrieben Vorteile hinsichtlich der Verschiebung hohe Werte von Schalldruckpegeln auf einen messbaren Bereich der Mikrofonmembran. Weiterhin bietet die Dämpfungsmembran einen zusätzlichen Schutz für das MEMS-Mikrofon bzw. dessen Komponenten, wie beispielsweise die elektronische Schaltung und/oder die Mikrofonmembran.

Bevorzugt bildet sich durch das Anbringen der Dämpfungsmembran und die Erstreckung dieser über die Schalleintrittsöffnung ein geschlossenes System. Hierdurch werden vorzugsweise innere Komponenten des MEMS-Mikrofons hermetisch abgeriegelt. Unter einem hermetischen Verschluss ist bevorzugt ein absolut dichter, insbesondere ein Austausch von Luft und/oder Wasser verhindernder Abschluss gemeint. Hierdurch werden vorteilhafterweise Komponenten des MEMS-Mikrofons geschützt und die Lebenszeit erhöht.

Bevorzugt ist die laterale Ausdehnung der Dämpfungsmembran auf die laterale Ausdehnung der Schalleintrittsöffnung abgestimmt.

Eine laterale Ausdehnung bezeichnet hierbei bevorzugt die seitliche, insbesondere nach außen und/oder entlang einer Oberfläche erstreckte Ausdehnung der Dämpfungsmembran. Die laterale Ausdehnung bezeichnet bevorzugt eine maximale laterale Ausdehnung des Dämpfungsmembran in deren Ebene. Im Falle der Form eines Kreises ist laterale Ausdehnung mithin durch einen Durchmesser gegeben.

In einer bevorzugten Ausführungsform kann die laterale Ausdehnung der Dämpfungsmembran im Wesentlichen der lateralen Ausdehnung der Schalleintrittsöffnung des MEMS-Mikrofons entsprechen. So kann es bevorzugt sein, dass sich die Dämpfungsmembran mindestens über die Schalleintrittöffnung erstreckt, sodass diese von der Dämpfungsmembran vollständig bedeckt ist. Es kann aber auch bevorzugt sein, dass die Dämpfungsmembran geringfügig kleiner ist, als die Schalleintrittsöffnung, sodass ein kleinerer schwingfähiger Bereich schallaufwärts vor der der Schalleintrittsöffnung liegt.

Bei einer Schalleintrittsöffnung mit einem Durchmesser von beispielsweise ca. 500 µm, kann die die Dämpfungsmembran vorzugsweise einen Durchmesser von mindestens ca. 500 µm aufweisen, beispielsweise einen Durchmesser von ca. 600 µm, ca. 700 µm, ca. 800 µm, ca. 900 µm, ca. 1000 µm oder mehr. Es kann aber auch bevorzugt sein, dass die Dämpfungsmembran einen geringeren Durchmesser als die Schalleintrittsöffnung aufweist, in Bezug auf obiges Beispiel, beispielweise einen Durchmesser von ca. 400 µm, ca. 300 µm, ca. 200 µm oder weniger.

Bevorzugt kann das Verhältnis der lateralen Ausdehnung der Dämpfungsmembran zur lateralen Ausdehnung der Schalleintrittsöffnung mehr als 0,5, 0,6, 0,7, 0,8, 0,9, 1,0, 1,1, 1,2, 1,3, 1,4, 1,5, 2, 3 oder mehr betragen und/oder weniger als 10, 9, 8, 7, 6, 5, 4, 3 oder weniger. Ein Fachmann erkennt, dass Zwischenbereiche aus den vorgenannten Parametern bevorzugt sein können, beispielsweise zwischen 0,8 und 3, zwischen 1,1 und 2 oder auch zwischen 1,5 und 5.

Die laterale Ausdehnung - beispielsweise ein Durchmesser bzw. Radius - der Dämpfungsmembran ist ein weiterer Parameter, welcher Einfluss auf die Wirkung der Dämpfungsmembran hat. In Fig. 9 E wird die Abhängigkeit der Reduktion des Schalldruckpegels vom Radius der Dämpfungsmembran gezeigt. Ein niedrigerer Radius und damit eine niedrigere laterale Ausdehnung der Dämpfungsmembran führt zu einer stärkeren Dämpfung und erhöht den möglichen messbaren Bereich des Schalldruckpegels.

In einer weiteren bevorzugten Ausführungsform ist das erfindungsgemäße System dadurch gekennzeichnet, dass das MEMS-Mikrofon ein kapazitives, piezoelektrisches und/oder piezoresistives MEMS-Mikrofon und/oder ein Elektretmikrofon ist.

Bei einem piezoelektrischen Mikrofon ist die Mikrofonmembran mechanisch mit einem piezoelektrischen Element gekoppelt, das durch die Druckschwankungen minimal verformt wird. Durch den piezoelektrischen Effekt ergibt sich durch die Verformung des piezoelektrischen Elements Spannungsschwankungen. Diese Spannungsschwankungen werden an die elektronische Schaltung übertragen und ausgelesen. Piezoelektrische Mikrofone sind vorteilhafterweise mechanisch robust und weisen eine simple Bauweise auf. Insbesondere sind sie vorteilhaft, da sie keine äußere Spannungsversorgung benötigen. Zudem sind sie unempfindlich gegenüber hohen Temperaturen.

Ein piezoresistives Mikrofon misst die mechanische Spannung anhand einer elektrischen Widerstandsänderung einer auf der Mikrofonmembran liegenden Struktur aus piezoresistivem Material. Die Piezowiderstände können hierbei in einer Wheatstoneschen Brückenschaltung auf der Mikrofonmembran verschaltet werden. Aufgrund des einfachen Aufbaus können piezoresistive Mikrofone monolithisch integriert werden.

Bei einem kapazitiven Mikrofon ist die Mikrofonmembran von einer Elektrodenschicht, beispielsweise aus einem Metall oder einem Halbleiter, die insbesondere eine Rückwand bilden kann, elektrisch isoliert angebracht. Technisch betrachtet ist diese Anordnung analog zu einem Plattenkondensator mit einem Luft-Dielektrikum, das eine elektrische Kapazität besitzt. Diese ist abhängig von der Plattenfläche und dem Abstand der Kondensatorplatten. Auftreffender Schall bringt die Mikrofonmembran zum Schwingen, wodurch sich der Abstand zwischen Membran und Gegenelektrode und damit auch die Kapazität des Kondensators verändert, welches von der elektronische Schaltung festgestellt werden kann. Kapazitive Mikrofone sind im Stand der Technik von ihrem grundlegenden Aufbau und in ihrer Herstellung bekannt. Sie zeigen vorteilhafterweise eine hohe Sensitivität auf und sind ebenfalls temperaturunempfindlich.

Elektretmikrofone beruhen ebenso auf einem kapazitives Messprinzip und weisen ein Elektret auf. Ähnlich wie ein Permanentmagnet ein eingefrorenes magnetisches Feld trägt, trägt ein Elektret ein eingefrorenes elektrisches Feld. Dieses übernimmt die sonst bei Kondensatormikrofonen notwendige Vorspannung und erlaubt damit einen einfacheren Betrieb. Auf Grund der hohen Impedanz ist in den meisten Fällen ein Impedanzwandler notwendig.

Es gibt drei Bauformen von Elektretmikrofonen. Beim Diaphragma-Typ ist die Membran selbst das Elektret. Beim Front-Elektret-Typ ist das Elektret auf der Membran aufgebracht. Beim Back-Elektret-Typ ist das Elektret auf der feststehenden Elektrodenschicht, beispielsweise eine Metallschicht oder eine kleine Metallplatte, aufgebracht. Vorteilhafterweise besitzen Elektretmikrofone eine sehr kompakte Bauweise und haben nur geringe Herstellungskosten bei guter Signalqualität.

In einer weiteren bevorzugten Ausführungsform ist das erfindungsgemäße System dadurch gekennzeichnet, dass das MEMS-Mikrofon in einer Top-Port- oder Bottom-Port-Ausführung vorliegt und/oder innerhalb eines mehrlagigen Substrates, vorzugweise eines Waferstacks, integriert vorliegt.

Im Laufe der Entwicklung von MEMS-Mikrofonen haben sich unterschiedliche Gehäusetypen etabliert. Dabei lassen sich diese nach der Art ihrer Schallzuführung kategorisieren. Trifft der Schall über die Gehäuseunterseite auf die Mikrofonmembran, so spricht man von einem Bottom-Port MEMS-Mikrofon. Bottom-Port-Mikrofone erfordern zusätzlich eine Öffnung auf dem Substrat, auf dem sich die Komponenten des MEMS-Mikrofons befinden (auch Trägersubstrat genannt), denn nur so ist für Schallwellen der Weg zur Mikrofonmembran frei. Trifft der Schall über die Gehäuseoberseite auf den Sensor, so spricht man von einem Top-Port MEMS-Mikrofon.

Ob ein Top-Port- oder ein Bottom-Port-Mikrofon bevorzugt wird, richtet sich zumeist nach Faktoren wie der Anordnung des Mikrofons im Produkt und/oder nach Fertigungsgesichtspunkten.

Vorteilhaft lässt sich die erfindungsgemäße Dämpfungsmembran sowohl in MEMS-Mikrofon in einer Top-Port- oder Bottom-Port-Ausführung bereitstellen. Darüber hinaus kann auch eine Bereitstellung eines MEMS-Mikrofons sowie eines Dämpfungselementes innerhalb eines mehrlagigen Substrates, vorzugsweise eines Halbleitersubstrates erfolgen, welche auch als Waferstack bezeichnet werden.

In einer bevorzugten Ausführungsform liegt das MEMS-Mikrofon in der Bottom-Port-Ausführung vor, was auch als Bottom-Port-Mikrofon bezeichnet werden kann.

Bei Bottom-Port-Ausführungen liegt ein großes Luftvolumen im Rückvolumen des MEMS-Mikrofons vor, was es der Mikrofonmembran erleichtert, sich unter dem Einfluss der Schallwellen zu bewegen. Dies wiederum verbessert die Empfindlichkeit und den Signal-Rausch-Abstand des Mikrofons. Ein großes Rückvolumen ist auch vorteilhaft für Ansprechverhalten des erfindungsgemäßen Systems auf niedrige Frequenzen.

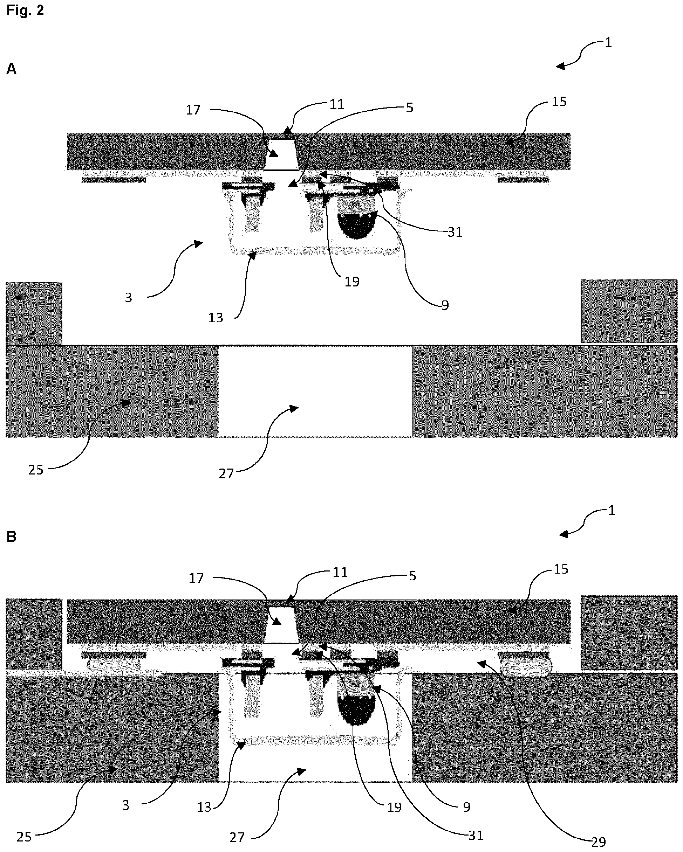

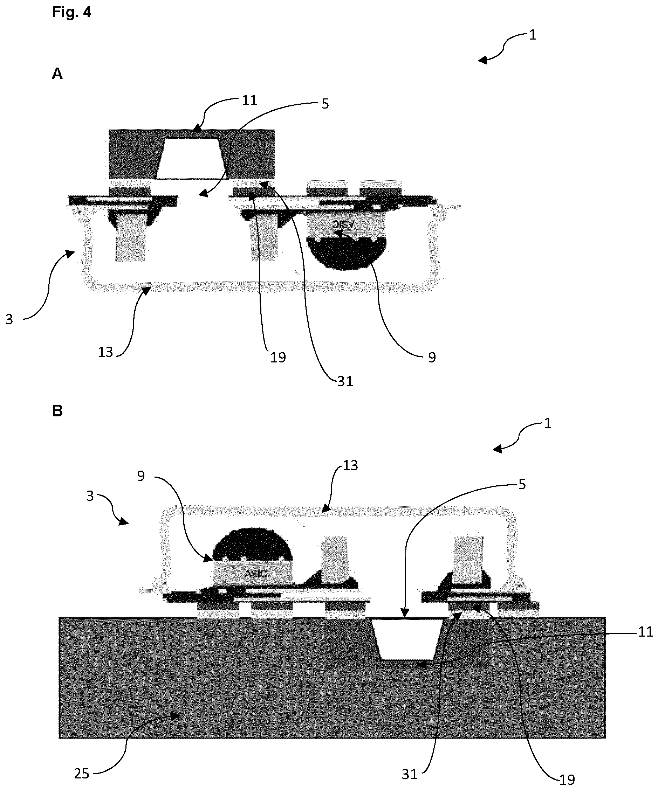

Die Dämpfungsmembran kann bevorzugt derart schallaufwärts vor der Schalleintrittsöffnung platziert werden, dass das Gehäuse innerhalb einer Kavität einer Leiterplatte hineinpasst und die Dämpfungsmembran sich entlang der Schalleintrittsöffnung erstreckt. Bevorzugt befindet die Dämpfungsmembran bei Bottom-Port-Mikrofone damit bevorzugt auf dem Trägersubstrat (siehe z.B. Fig. 2 A-B). Es kann ebenfalls bevorzugt sein, dass die Dämpfungsmembran bei der Bottom-Port-Ausführung innerhalb einer Kavität einer Leiterplatte befindet (siehe Fig. 4 B).

Es ist besonders bevorzugt, dass die Dämpfungsmembran in Bottom-Port-Ausführungen durch einen Interposer bereitgestellt wird. Die Kombination der Dämpfungsmembran mit Bottom-Port-Mikrofonen ist sehr vorteilhaft, da ein Interposer besonders einfach bearbeitet werden kann, um ein Bereitstellen einer Dämpfungsmembran und deren Verbindung mit dem MEMS-Mikrofon zu gewährleisten. Zudem ist es durch den Einsatz eines Interposers vorteilhafterweise möglich, gleichzeitig eine Dämpfungsmembran, eine elektrische Kontaktierung und einen akustischen Abschluss zu ermöglichen.

Insbesondere bei der Bottom-Port-Ausführung können weiterhin unterschiedliche Aufbauweisen unterteilt werden. Bekannte Aufbauweisen sind die Flip-Chip Montage und die Drahtbond Montage, welche ebenfalls für das erfindungsgemäße System vorgesehen sein können.

Bei der Flip-Chip Montage erfolgt die Verbindung zwischen Mikrofonmembran, elektronischer Schaltung und Trägersubstrat mittels eines Lots. Hierfür werden die Mikrofonmembran, die elektronische Schaltung und das Lot auf das Trägersubstrat aufgebracht und über einen Reflow-Prozess mechanisch und elektrisch miteinander verbunden.

Beim Reflow-Prozess wird bevorzugt ein Weichlot in Form von Lotpaste vor der Bestückung auf die aufgetragen. Hierin liegt der Hauptunterschied zu anderen Lötverfahren, wie Lötkolbenlöten, Tauchlöten oder Wellenlöten. Es gibt verschiedene Möglichkeiten des Lotauftrags, z. B. mittels Schablonendruck (Stencil, Siebdruck), Dispenser, durch Lotformteile (Preforms) oder auch galvanisch. Anschließend werden dann die Bauteile bestückt. Die Verwendung von Lotpaste hat den Vorteil, dass diese klebrig ist und so die Bauteile bei der Bestückung direkt an der Paste halten. Sie müssen also nicht eigens aufgeklebt werden. Das bestückte Trägersubstrat (beispielsweise eine Leiterplatte) wird stark genug erhitzt, so dass das in der Lotpaste enthaltene Lot schmilzt. Gleichzeitig aktiviert die erhöhte Temperatur das Flussmittel im Gel der Lotpaste. Die dafür eingesetzten Heizverfahren haben das Ziel, die Leiterplatte und die Komponenten möglichst gleichmäßig zu erwärmen. Die Oberflächenspannung des geschmolzenen Lots zieht die Bauteile auf die Mitte der Landepads.

Ein Vorteil der Flip-Chip Montage ist die kleine und kompakte Bauteilgröße. Bei der Flip-Chip Montage werden zusätzliche Bonddrähte nicht benötigt, da die elektrische und mechanische Verbindung direkt am Trägersubtrat erfolgt. Die mechanische Anbindung an das Trägersubstrat beeinflusst den Temperaturgang des Mikrofons. Durch die unterschiedlichen Längenausdehnungskoeffizienten der Materialien der Komponenten, wie beispielsweise Silizium, Trägersubstrat, Lot und Kleber, wird die mechanische Spannung der Mikrofonmembran beeinflusst. Dies führt zu einer Änderung der Auslenkung und damit zu einer Änderung der Sensitivität.

Bei der Drahtbond Montage erfolgt die Verbindung zwischen Mikrofonmembran, elektronische Schaltung und Trägersubstrat bevorzugt mittels Bonddrähten. Hierfür werden die Mikrofonmembran und die elektronische Schaltung vorweg beispielsweise mittels Kleber mit dem Trägersubstrat mechanisch und anschließend über Bonddrähte elektrisch verbunden. MEMS-Mikrofone der Bauweise einer Drahtbond Montage haben vorteilhafterweise ein großes Rückvolumen. Eine akustische Trennung bzw. eine Trennung von Bereichen des MEMS-Mikrofons erfolgt durch eine Unterteilung in Vor- und Rückvolumen. Das Vorvolumen umfasst vorzugsweise das Volumen ab der Schalleintrittsöffnung bis zur Mikrofonmembran und das Rückvolumen das Volumen hinter der Mikrofonmembran.

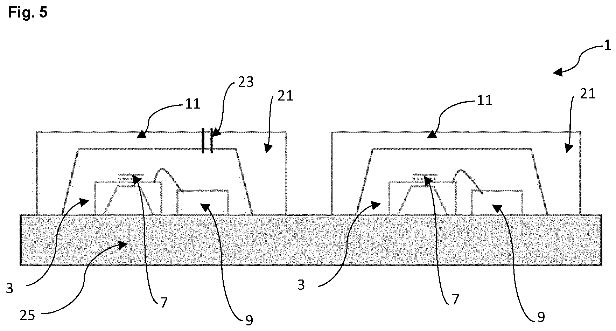

In Top-Port-Ausführungen eines MEMS-Mikrofons liegt die Dämpfungsmembran bevorzugt planar vor bzw. über der Schalleintrittsöffnung vor. Beispielsweise kann hierbei die Dämpfungsmembran durch das Gehäuse selbst oder einer zusätzlichen Mikrofonabdeckung bereitgestellt werden (siehe z. B. Fig. 5-6).

Das erfindungsgemäße System ist dadurch gekennzeichnet, dass das System einen Interposer umfasst und die Dämpfungsmembran in dem Interposer eingebracht vorliegt. Besonders bevorzugt erfolgt der Einbau eines Interposers bei einer Bottom-Port-Ausführung eines MEMS-Mikrofons.

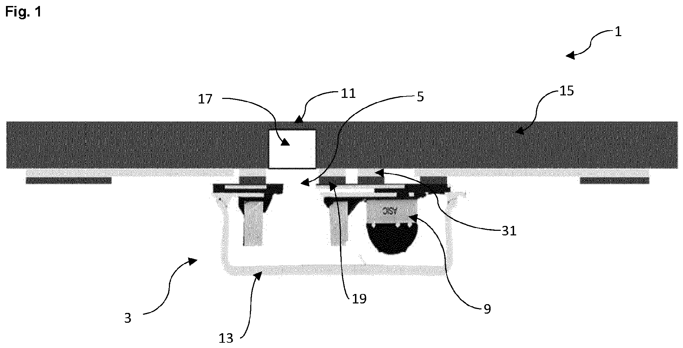

Beispielsweise kann die Dämpfungsmembran in einem Interposer durch das Einbringen einer Kavität in den Inteposer bereitgestellt werden. Die Kavität weist eine Grenzschicht auf, die die Kavität von der Umgebung des Interposers trennt. Diese Grenzschicht dient dabei als Dämpfungsmembran, die sich bevorzugt vor der Schalleintrittsöffnung befindet (siehe auch Fig. 1). Wie weiter oben angeschnitten, kann ein MEMS-Mikrofon in der Bottom-Port Ausführung auch mit dem Gehäuse in eine Kavität eines Schaltungsträger gebracht werden, wobei der Interposer mit der eingebrachten Kavität vor der Schalleintrittsöffnung befindet (siehe Fig. 2 B).

Das Vorliegen der Dämpfungsmembran in den Interposer hat sich als besonders vorteilhaft erwiesen. Insbesondere kann durch den Einsatz eines Interposers gleichzeitig eine Dämpfungsmembran, eine elektrische Kontaktierung und ein akustischer Abschluss bereitgestellt werden. Damit wird ein synergistischer Effekt erzielt, der auf besonders herstellungseffiziente Weise - nämlich der Anbringung eines Interposers - bereitstellbar ist. Auch für die Messung als solche von Schallereignissen hat sich der Interposer im erfindungsgemäßen Kontext als nützlich erwiesen, da, insbesondere im Hinblick auf elektrische Kontaktierungen, Leitungswege verkürzt werden konnten, sodass ein optimierter Signaltransfer sowie eine gleichzeitige Energieersparnis pro Fläche erzielt wird.

In einer weiteren bevorzugten Ausführungsform ist das erfindungsgemäße System dadurch gekennzeichnet, dass das MEMS-Mikrofon mit einem Schaltungsträger, vorzugsweise einer Leiterplatte, kontaktiert vorliegt, wobei der Schaltungsträger, vorzugsweise eine Leiterplatte, eine Kavität zur Aufnahme des MEMS-Mikrofons aufweist. Bevorzugt vermittelt der Interposer eine elektrische Kontaktierung des MEMS-Mikrofons zu einem Schaltungsträger, vorzugweise einer Leiterplatte. Hierbei wird bevorzugt das MEMS-Mikrofon auf dem Schaltungsträger platziert (siehe Fig. 4 B). Vorteilhafterweise bietet die Kavität einen optimalen Schutz für das MEMS-Mikrofon, da das MEMS-Mikrofon optimal in die Kavität hineinpasst und das Dämpfungselement über der Kavität, in der sich das MEMS-Mikrofon befindet, vor dem Eindringen von unerwünschten Stoffen schützt. Die Kavität kann dabei in dem Schaltungsträger angebracht vorliegen und besonders einfach angebracht werden. Dabei ist die Kavität innerhalb des Schaltungsträgers auch vorteilhaft, um Leitungswege zu verkürzen und besonders gut und effizient elektrische Signale zu übertragen. Innerhalb der Kavität sitzt das MEMS-Mikrofon auch besonders stabil, robust und fest, sodass bei Beanspruchungen, beispielsweise durch Verschiebungen und/oder Bewegungen, des erfindungsgemäßen Systems es zu keinerlei Verschiebungen des MEMS-Mikrofons kommt. Dadurch erhöht sich vorteilhafterweise die gesamtheitliche Bauteilqualität und die Lebenszeit des erfindungsgemäßen System. Die Kavität kann also vorteilhafterweise als ein Schutzraum für das MEMS-Mikrofon gesehen werden, wobei besonders einfach und effizient elektrische Signale aus und/oder in die Kavität, in der sich das MEMS-Mikrofon befindet, übertragen werden können.

Die Kavität bezeichnet einen Hohlraum, welches ein Volumen aufweist. Innerhalb dieses Volumens kann sich das MEMS-Mikrofon befinden. Die Kavität weist im Wesentlichen die gleichen Ausmaße wie das MEMS-Mikrofon auf, kann aber nach Belieben höhere oder auch niedrige Ausmaße besitzen.

Vorteilhafterweise bietet ein Interposer die Möglichkeit, die Dämpfungsmembran bereitzustellen mit einer gleichzeitigen elektrischen Kontaktierung. Insbesondere erlaubt der Interposer neben der Dämpfungsfunktion gleichzeitig eine Bereitstellung von Zwischenschaltungen, Durchkontaktierungen und/oder Umverdrahtungen Zudem stellt der Interposer einen akustischen Abschluss dar.

Ein Interposer bezeichnet im Stand der Technik bevorzugt eine Zwischenschicht bzw. eine Bauelement, welches elektrische Verbindungen zwischen zwei oder mehr Anschlüssen vermittelt. Der Zweck eines Interposers ist zumeist es, einen Anschluss auf ein breiteres Raster von Anschlüssen zu verteilen oder einen Anschluss auf einen anderen Anschluss umzuleiten. Ein Beispiel Interposers betrifft die Bereitstellung eines sogenannten Ball Grid Arrays (deutsch Kugelgitteranordnung), der eine Gehäuseform von Integrierten Schaltungen darstellt, bei der die Anschlüsse für eine SMD-Bestückung kompakt auf der Unterseite des Bauelements liegen. Die Anschlüsse sind kleine Lotperlen (engl. balls), die nebeneinander in einer Gitterform aus Spalten und Zeilen stehen. Diese Perlen werden bei einem Reflow-Prozess in einem Lötofen aufgeschmolzen und verbinden sich mit Kontaktpads auf der Leiterplatte. Ein Ball Grid Array als Interposer vermittelt somit einer Verbindung zwischen Anschlüssen eines Die mit integrierter Schaltung (auf der Oberseite des Interposers) und den Anschlüssen bzw. Kontaktpads (auf der Unterseite des Interposers) einer Leiterplatte.

Im Kontext der Erfindung ist der Interposer bevorzugt ein Bauelement, welches eine Verbindung zwischen ersten Anschlüssen des MEMS-Mikrofons zu zweiten Anschlüssen eines Schaltungsträgers (vorzugsweise einer Leiterplatte) vermittelt. Das Bauelement ist vorzugsweise flächig ausgestaltet und kann daher als Schicht bezeichnet werden. Für obig beschriebenes Beispiel eines Ball Grid Arrays stellt der Interposer eine Zwischenschicht dar, welche eine Verbindung zwischen Anschlüssen einer Seite (Oberseite) zu einer gegenüberliegenden Seite (Unterseite) vermittelt.

Im Sinne der Erfindung kann es bevorzugt sein, dass der Interposer ebenso eine Verbindung zwischen Anschlüssen für das MEMS-Mikrofons und einen Schaltungsträger (vorzugsweise einer Leiterplatte) von einer zu anderen Seite des Interposers vermittelt. Besonders bevorzugt vermittelt der Interposer jedoch eine Verbindung zwischen Anschlüssen für das MEMS-Mikrofons (insbesondere in einer Bottom-Port Ausführung) und einem Schaltungsträgers (vorzugsweise Leiterplatte) auf derselben Seite des Interposers (vgl. u.a. Fig. 1-3).

Der Interposer kann im Sinne der Erfindung daher bevorzugt auch als ein Deckel bzw. eine Deckschicht bezeichnet werden. Besonders bevorzugt schließt der Interposer als Deckel bzw. Deckschicht, das MEMS-Mikrofon von einer Seite (an der die Schalleintrittsöffnung) vorliegt ab t und vermittelt bevorzugt auf der das MEMS-Mikrofon kontaktierende Seite eine Verbindung zur Anschlüssen einer Leiterplatte.

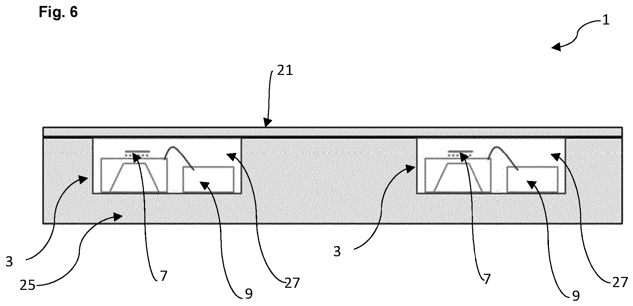

Der Interposer kann bevorzugt sowohl flexible als auch starre Materialien umfassen. Insbesondere sind starre Interposer bevorzugt, da eine besonders feste und robuste Verbindung mit dem MEMS-Mikrofon hergestellt werden kann und das MEMS-Mikrofon im Sinne eines Deckels oder einer Mikrofonabdeckung schützen kann (vgl. u.a. Fig. 6-7).

Besonders geeignete Materialien für den Interposer sind aufgrund der Verarbeitungsmöglichkeiten und der geringen Produktionskosten Silizium, Glas und/oder Polymid. Der Interposer kann durch im Stand der Technik bekannte Klebe- Löt- und/oder Bondverfahren am MEMS-Mikrofon befestigt werden.

In dem Interposer liegt die Dämpfungsmembran bevorzugt integriert vor, sodass der Interposer gleichzeitig der Kontaktierung des MEMS-Mikrofons mit einem Schaltungsträger dient, als zudem eine vorteilhafte elastische Dämpfung vermittelt.

In einer bevorzugten Ausführungsform wird die Dämpfungsmembran durch Einbringen einer Kavität in einem Interposer gebildet, welcher vorzugsweise als eine Deckschicht bzw. Deckel auf dem MEMS-Mikrofon aufgebracht werden kann. Beispielsweise kann der Interposer als ein flächiger Deckel bzw. eine Schicht im Wesentlichen aus einem elastischen Material vorliegen, wobei eine Kavität derart eingebracht wird, dass eine Dämpfungsmembran mit gewünschter Dicke im Interposer bestehen bleibt. Für das elastische Material des Interposers (und mithin der Dämpfungsmembran) sind analog zu obigen Ausführungen insbesondere Materialien bevorzugt ausgewählt aus einer Gruppe umfassend monokristallines Silizium, Polysilizium, Siliziumdioxid, Siliziumnitrid, Siliziumcarbid, Siliziumgermanium, Siliziumnitrid, Nitrid, Germanium, Kohlenstoff, Galliumarsenid, Galliumnitrid, Indiumphosphid, Glas und/oder einem Metall.

Die Position und laterale Ausdehnung der Kavität im Interposer kann vorzugsweise so gewählt werden, dass im verbundenen Zustand die Dämpfungsmembran des Interposers vor bzw. oberhalb der Schalleintrittsöffnung des MEMS-Mikrofons vorliegt.

In einer bevorzugten Ausführungsform ist das erfindungsgemäße System dadurch gekennzeichnet, dass die Dämpfungsmembran durch Einbringen einer Kavität in dem Interposer gebildet, wobei bevorzugt eine Tiefe der Kavität derart gewählt wird, dass die in dem Interposer gebildete Dämpfungsmembran eine Dicke von 50 nm bis 500 µm, bevorzugt 100 nm bis 200 µm, besonders bevorzugt 1 µm bis 50 µm aufweist und/oder eine laterale Ausdehnung von 100 µm bis 2000 µm, vorzugsweise 200 µm bis 1000 µm aufweist.

Die genannten Werte hinsichtlich der Dicke und der lateralen Ausdehnung der Dämpfungsmembran durch Bilden einer Kavität im Interposer - insbesondere in Kombination mit den genannten Materialien - haben sich dahingehend als sehr vorteilhaft erwiesen, dass sie einen Teil des Schalldruckpegels unverzerrt verschieben können, sodass insbesondere hohe Werte von Schalldruckpegeln durch die Mikrofonmembran gemessen werden können.

Durch Auswahl des elastischen Materials und der Dicke können Werte von ca. 10 dB, ca. 20 dB, ca. 30 dB, ca. 40 dB, ca. 50 dB oder mehr vorteilhaft unverzerrt verschoben werden.

Dabei kann die Kavität mittels Ätzverfahren erhalten werden, die sich im Stand der Technik als effizient, schnell, zuverlässig und kostengünstig etabliert haben.

Die Begriffe "Ätzverfahren" und "Ätzprozesse" können synonym verwendet werden. Ein Ätzverfahren bezeichnet bevorzugt die Abtragung von Material einer Oberfläche. Die Abtragung kann sich in Form von Vertiefungen veräußern, die Kavitäten hinterlassen, wobei eine Grenzschicht zur Kavität das Dämpfungselement oder die Dämpfungsmembran hinterlässt.

Geeignete Ätzverfahren zur Bildung einer Dämpfungsmembran mit gewünschter Dicke wären beispielsweise nasschemische Ätzverfahren und/oder Trockenätzverfahren, bevorzugt physikalische und/oder chemische Trockenätzverfahren, besonders bevorzugt durch reaktives Ionenätzen und/oder reaktives Ionentiefenätzen (Bosch-Prozess), oder eine Kombination der vorgenannten Ätzverfahren.

Unter Trockenätzen fasst man in der Halbleitertechnologie und in der Mikrosystemtechnik eine Gruppe von abtragenden Mikrostrukturverfahren zusammen, die nicht auf nasschemischen Reaktionen (wie nasschemisches Ätzen, chemisch-mechanisches Polieren) basieren. Der Materialabtrag erfolgt dabei entweder durch beschleunigte Teilchen oder mithilfe plasmaaktivierter Gase.

Trockenätzverfahren lassen sich in drei Gruppen einordnen: Physikalischen Trockenätzverfahren, sie basieren auf dem Materialabtrag durch Beschuss mit Teilchen, chemische Trockenätzverfahren, sie basieren auf einer chemischen Reaktion eines meist plasmaaktiverten Gases und physikalisch-chemischen Trockenätzverfahren, die beide Wirkmechanismen nutzen.

Beim nasschemischen Ätzen wird eine ätzresistente Maskierung durch einen chemischen Abtragungsprozess in den Wafer übertragen.

Plasmaätzen ist ein materialabtragendes, plasmaunterstütztes Trockenätzverfahren. Beim Plasmaätzen unterscheidet man zwischen einem Ätzabtrag aufgrund einer chemischen Reaktion und einem physikalischen Abtrag der Oberfläche aufgrund von Ionenbeschuss.

Beim chemischen Plasmaätzen erfolgt der Materialabtrag durch eine chemische Reaktion. Deshalb ist es im Allgemeinen isotrop und aufgrund des chemischen Charakters auch sehr materialselektiv. Beim physikalischen Plasmaätzen, auch plasmaunterstütztes Ionenätzen genannt, handelt es sich um ein physikalisches Verfahren. Bei diesem Verfahren kann eine gewisse Vorzugsrichtung im Ätzangriff entstehen, daher weisen die Verfahren unter Umständen eine Anisotropie im Materialabtrag auf.

Hierbei sind im Besondere das reaktive Ionenätzen (engl. reactive ion etching, RIE), ein ionenunterstützter Reaktivätsprozess mit sehr guter Kontrollierbarkeit des Ätzverhaltens, und das reaktiver Ionentiefenätzen (engl. deep reactive ion etching, DRIE), eine Weiterentwicklung des RIE, zu erwähnen.

Die genannten Ätzprozesse sind einem durchschnittlichen Fachmann in ihrer Ausführung bekannt. In Abhängigkeit der gewünschten Dicke der Dämpfungsmembran und/oder des Materials des Interposers können vorteilhafte Verfahren gewählt werden, um eine effiziente Durchführung zu gewährleisten.

In einer bevorzugten Ausführungsform weist der Interposer eine Dicke bis zu 1000 µm, bevorzugt bis zu 700 µm, besonders bevorzugt zwischen 400 und 700 µm, auf.

Derartige Schichtdicken stellen sich, dass der Interposer besonders stabil und robust ist und zudem eine Dämpfungsmembran mit bevorzugter Dicken von 50 nm bis 500 µm, bevorzugt 100 nm bis 200 µm, besonders bevorzugt 1 µm bis 50 µm effizient und sicher eingebracht werden kann.

Ein Schaltungsträger ist bevorzugt ein Bauelement umfassend ein elektrisch isolierendes Material auf dem elektrisch leitende Verbindungen (Leiterbahnen) und/oder elektronische Bauelemente bzw. Baugruppen vorliegen, bevorzugt aus der Halbleitertechnik und der Mikrosystemtechnik.

Insbesondere weist ein Schaltungsträger metallische Leiterbahnen auf, sodass elektrische Verbindungen hergestellt werden können. Sie dienen bevorzugt zur Strom- bzw. Spannungsversorgung, Signalübertragung und/oder auch zur Temperaturableitung.

In bevorzugten Ausführungsformen ist der Schaltungsträger eine Leiterplatte (Platine, engl. *printed circuit board),* wobei sowohl konventionelle (steife) Leiterplatten, als auch eine flexible Leiterplatten (engl. *flexible printed circuits)* zum Einsatz kommen können.

Leiterplatten umfassen elektrisch isolierendes Material mit daran haftenden, leitenden Verbindungen, den Leiterbahnen. Als isolierendes Material ist faserverstärkter Kunststoff, bei günstigeren Geräten Hartpapier, üblich. Die Leiterbahnen werden zumeist aus einer dünnen Schicht umfassend Kupfer geätzt. Die Bauelemente werden auf Lötflächen (Pads) oder in Lötaugen gelötet. So werden sie an diesen Stellen gleichzeitig mechanisch stabil gehalten und elektrisch verbunden. Größere Komponenten können auch mit Kabelbindern, Klebstoff oder Verschraubungen auf der Leiterplatte befestigt werden.

Die Bereitstellung eines Interposer mit integrierter Dämpfungsmembran und Kontaktvermittlung zu einem Schaltungsträger (vorzugsweise einer Leiterplatte) erlaubt eine äußerst kompakte und robuste Bauweise des Systems. Durch den Schaltungsträger können zudem weitere elektrischen und mechanischen Funktionen realisiert und beliebige Formen gestaltet werden.

Ein Vorteil ist die Handhabbarkeit und Automatisierbarkeit bei der Kontaktierung mit einer Leiterplatte über einen Interposer.

In einer weiteren bevorzugten Ausführungsform ist das erfindungsgemäße System dadurch gekennzeichnet, dass eine geschlossene elektrische Verbindung zwischen dem MEMS-Mikrofon und dem Interposer, vorzugsweise in Form eines Lötrings, um die Schalleintrittsöffnung gebildet wird, welche sowohl eine elektrische Kontaktierung zwischen MEMS-Mikrofon und Interposer als einen akustischen Abschluss vermittelt. Besonders bevorzugt erfolgt die elektrische Kontaktierung durch ein Lötring um die Schalleintrittsöffnung in der Bottom-Port-Ausführung eines MEMS-Mikrofons.

Vorteilhafterweise wird hierbei eine besonders stabile und robuste elektrische und mechanische Verbindung zwischen MEMS-Mikrofon und Interposer gebildet. Insbesondere wirkt die Verbindung zudem als akustischer Abschluss des MEMS-Mikrofons.

Ein Lötring bezeichnet bevorzugt ein Material (bevorzugt Lötmaterial), welches im Wesentlichen ringförmig, also insbesondere geschlossen, am Interposer strukturiert vorliegt und zum Befestigen des MEMS-Mikrofons mit dem Interposer dient, bevorzugt über Lötprozesse. Auch andere Prozesse wie Bonden und/oder Kleben können zum Einsatz kommen.

Ein akustischer Abschluss bezeichnet bevorzugt einen Abschlusswiderstand in Bezug auf elektrische Signale, welche durch die Schallwellen hervorgerufen werden. Abschlusswiderstände sind Widerstände an Leitungsenden, die der Impedanz der Leitung bzw. elektrischen Verbindung entsprechen und dieses Impedanz-richtig abschließen. Durch den Impedanz-richtigen Abschluss laufen die auf dem Übertragungsmedium übertragenen Wellen im Unendlichen aus und können nicht reflektiert werden (auch nicht teilweise).

In einer weiteren bevorzugten Ausführungsform ist das erfindungsgemäße System dadurch gekennzeichnet, dass ein Zwischenraum zwischen dem MEMS-Mikrofon, einem Interposer und/oder einem Schaltungsträger, vorzugsweise einer Leiterplatte, mit einem Füllmaterial befüllt wird.

Vorteilhafterweise ergibt sich durch die Befüllung des Zwischenraumes mit einem Füllmaterial eine besonders hohe Stabilisierung und ein rückseitiger Abschluss. Insbesondere wird durch das Füllmaterial hinsichtlich der Stabilisierung das Mitschwingen des Interposers und/oder des Schaltungsträgers weitestgehend verhindert, die mit der Dämpfungsmembran gekoppelt ist. Insbesondere wird hierbei zur Verschiebung auf ein messbaren Pegel vorzugsweise nur die Dämpfungsmembran in Schwingungen versetzt, also insbesondere der Bereich über der Schalleintrittsöffnung, aber nicht laterale Bereiche des Interposers und/oder der Zwischenschaltung. Vorteilhafterweise wird hierbei auch nur die Dämpfungsmembran mechanisch beansprucht und nicht gesamte Interposer und/oder Schaltungsträger. Damit ergeben sich besonders genaue Messergebnisse. Insbesondere werden hohe Werte des Schalldruckpegels unverzerrt auf einen für die Mikrofonmembran messbaren Bereich verschoben.

Ein Zwischenraum bezeichnet hierbei bevorzugt einen oder mehrere Spalten zwischen dem MEMS-Mikrofon, dem Interposer und/oder dem Schaltungsträger. Ohne die Befüllung würde der Zwischenraum lediglich Luft oder ein Vakuum aufweisen. Der Zwischenraum kommt zustande, wenn eine oder mehrere einander berührende Komponenten eine andere Form als ein Rechteckprofil aufweisen. Der Zwischenraum kann eine geplante Sollbruch- oder Trennstelle der Komponenten sein, die unbeweglich zueinander montiert sind oder aufeinander fixiert werden.

In einer weiteren bevorzugten Ausführungsform ist das erfindungsgemäße System dadurch gekennzeichnet, dass das Füllmaterial einen oder mehrere Polymere, vorzugsweise einen oder mehrere zyklische, lineare, verzweigte und/oder vernetzte Polysiloxane umfasst.

Die genannten Materialien sind dahingehend sehr vorteilhaft als Füllmaterial, da sie ein gutes Beständigkeitsverhalten zeigen. So bleibt das Füllmaterial in einem weiten Temperaturbereich (z. B. von ca. -40 °C bis ca. +150 °C) zum einen in seinem mechanischen Verhalten stabil, zum anderen aber auch in seinem optischen, d. h. im Vergleich zu anderen Kunststoffen tritt mit der Zeit keine Vergilbung auf. Ein weiterer Vorteil besteht darin, dass die genannten Materialien eine gewisse Elastizität aufweisen. Diese kann beispielsweise dann relevant sein, wenn es zu hohen mechanischen Beanspruchungen, beispielsweise durch Wirkung von sehr hohen Drücken, wie sie in der Aeroakustik üblich sind, kommt. Dadurch bleibt die Funktionalität des erfindungsgemäßen Systems trotz der Wirkung von beispielsweise hohen Kräften bestehen. Aufgrund der relativ schwachen intermolekularen Bindungen der voran genannten Materialien weisen sie zudem eine geringe Viskosität auf, welche bei der Herstellung und Verarbeitung von Vorteil sein kann. Die verhältnismäßig niedrige Viskosität geht auch mit fertigungstechnischen Vorteilen einher. Die Prozesse sind einfacher zu handhaben, man kann geringe Zykluszeiten realisieren und in sehr engen Toleranzen fertigen. Außerdem lassen sich durch das Fließverhalten des Materials sehr komplexe Geometrien abformen.

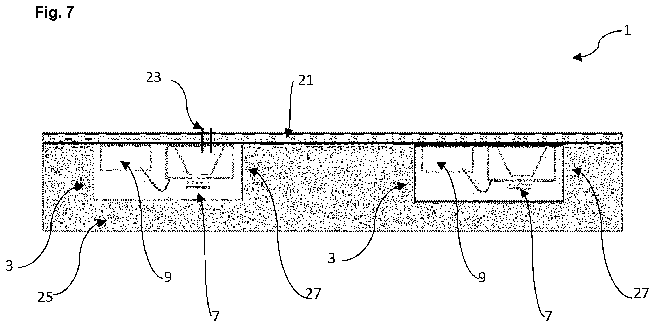

In einer weiteren bevorzugten Ausführungsform ist das erfindungsgemäße System dadurch gekennzeichnet, dass die Dämpfungsmembran in einer Mikrofonabdeckung integriert vorliegt bzw. von dieser gebildet wird, wobei die Mikrofonabdeckung optional eine Öffnung für einen Druckausgleich umfasst. Bevorzugt kann die Mikrofonabdeckung als Dämpfungsmembran im Falle einer Top-Port-Ausführung eines MEMS-Mikrofons genutzt werden (siehe z.B. Fig. 5-6). Insbesondere kann dabei die Dämpfungsmembran durch das Gehäuse oder durch eine zusätzlich angebrachte Abdeckung bereitgestellt werden. Die Mikrofonabdeckung kann beispielsweise eine oder mehrere Folien oder eine Membran umfassen, die aus Metall, Glas, und/oder einem oder mehreren Polymeren gebildet sind. Die Mikrofonabdeckung kann auch in Form eines Deckels vorliegen. Es kann ebenso bevorzugt sein, dass die Mikrofonabdeckung bei einer Bottom-Port-Ausführung eines MEMS-Mikrofons angebracht wird (siehe Fig. 7). Bei der Bottom-Port-Ausführung wird das die Mikrofonabdeckung bevorzugt derart angebracht, dass sich diese laterale entlang der Schalleintrittsöffnung erstreckt und auf dem Trägersubstrat befindet.

Vorteilhafterweise ist das Anbringen der Dämpfungsmembran, insbesondere durch Ätzprozesse zur Bildung der Dämpfungsmembran, bei einer Mikrofonabdeckung besonders einfach. Gleichzeitig liefert die Mikrofonmembran einen hervorragenden Schutz für das MEMS-Mikrofon. Hierbei kann die Mikrofonabdeckung sich über einen Bereich der Schalleintrittsöffnung, über einen weiteren Bereich oder entlang einer gesamten Oberfläche über der Schalleintrittsöffnung befinden. Weiterhin ist es vorteilhaft, dass besonders einfach Öffnungen in die Mikrofonmembran angebracht werden können, die vorzugsweise dazu dienen, einen Druckausgleich zwischen der Umgebung des erfindungsgemäßen System und dem erfindungsgemäßen System selbst zu ermöglichen. Insbesondere kann die Mikrofonabdeckung ein schwingfähiges Material, beispielsweise ein schwingfähiges Polymer umfassen, sodass hohe an der Mikrofonmembran gemessene Schallgrößen, wie z. B. hohe Schalldruckpegel, unverzerrt auf messbare Bereiche verschoben werden, beispielsweise um mindestens ca. 10 dB, ca. 20 dB, ca. 30 dB oder mehr. Insbesondere erfolgt kein Verlust an Bandbreiten des gemessenen Signals und das Signal-Rausch-Verhältnis bleibt gleich.

Als Druckausgleich wird bevorzugt ein Vorgang bezeichnet, bei dem zwischen dem erfindungsgemäßen System und seiner Umgebung, die bevorzugt mit demselben Medium gefüllt sind, im Wesentlichen der gleiche Druck hergestellt wird. Das Medium kann entweder ein Gas oder eine Flüssigkeit sein, insbesondere auch Luft. Vorzugsweise wird der Druckausgleich durch den Transport vom Medium zwischen der Umgebung und dem erfindungsgemäßen System bewerkstelligt. Vorteilhafterweise wird durch einen Druckausgleich ein im Wesentlichen gleiches Schwingungsverhalten von der Dämpfungsmembran und der Mikrofonmembran ermöglicht. Fände kein Druckausgleich statt, könnte sich dies nachteilig auf die Sensitivität und auf den gesamtheitlichen Funktionsbetrieb auswirken. Daher ist es bevorzugt, dass durch an der Mikrofonabdeckung angebrachte Öffnungen ein Druckausgleich stattfindet.

Die Mikrofonabdeckung bezeichnet bevorzugt eine Komponente des erfindungsgemäßen Systems, die im Verhältnis zu ihrer Dicke eine große flächige Ausdehnung hat. Insbesondere ist die Mikrofonmembran eine biaxial gespannte Fläche, die die Fähigkeit zur Abtrennung und/oder zur Schwingung hat. Die Mikrofonabdeckung kann beispielsweise Folien oder eine Membran umfassen, die aus Metall, Glas, und/oder einem oder mehreren Polymeren gebildet sind. Die Mikrofonabdeckung kann auch in Form eines Deckels angebracht werden, das Gehäuse oder Teil des Gehäuses sein.

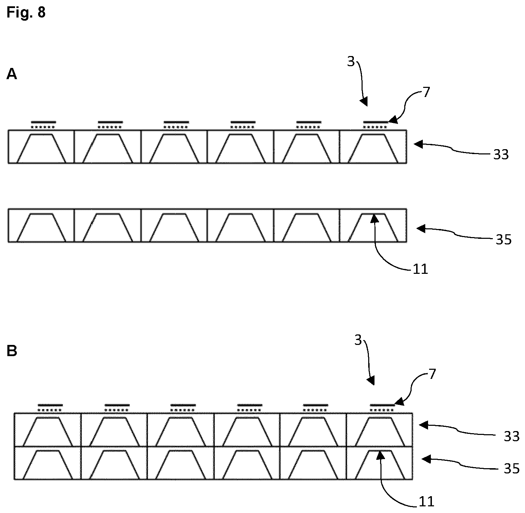

In einer weiteren bevorzugten Ausführungsform ist das erfindungsgemäße System dadurch gekennzeichnet, dass das System mindestens zwei Wafer umfasst, welche einen Waferstack bilden, wobei das MEMS-Mikrofon in einem ersten Wafer und die Dämpfungsmembran in einem zweiten Wafer gebildet vorliegt. Vorzugsweise kann die Dämpfungsmembran durch eine Kavität innerhalb eines Wafers vorliegen. Bevorzugt werden die Wafer derart miteinander verbunden, dass sich die Dämpfungsmembran vor der Schalleintrittsöffnung befindet (siehe Fig. 8 A-B).

Die Bildung eines mehrlagigen Substrats, vorzugsweise eines Waferstacks, wird aus mindestens zwei Wafern gebildet, kann aber auch 3, 4, 5, 6, 7, 10, 15, 20 oder mehr Wafer umfassen. Die Wafer können dabei sowohl horizontal als auch vertikal in zwei oder mehr Schichten miteinander verbunden werden, sodass sich eine dreidimensionale Ausgestaltung bildet. Vertikale elektrische Verbindungen zwischen verschiedenen Wafern werden dabei durch Durchkontaktierungen ermöglicht. Zwischen den Wafern eines Waferstacks können sich auch weitere Schichten, wie beispielsweise eine oder mehrere Oxidschichten, befinden.

Vorteilhafterweise ergibt sich hierdurch eine geringere Grundfläche. Es passen mehr funktionelle Komponenten auf eine geringere Fläche des Bauelementeträgers, z. B. auf der Leiterplatte. Dies ermöglicht kleinere und gleichzeitigt leistungsstarke MEMS-Mikrofone. Zudem ist die Bauweise vorteilhafterweise mit geringeren Herstellungskosten verbunden. Des Weiteren ist es von Vorteil, dass die Herstellung der einzelnen Komponenten zu einem viel höheren Grad optimiert werden kann, als wenn sie gemeinsam auf einem einzelnen Substrat hergestellt werden. Insbesondere ist damit gemeint, dass man Komponenten unterschiedlicher und inkompatibler Herstellungstechniken in einem Waferstack zusammenfügen kann. Darüber hinaus ergeben sich kürzere Signalwege und eine geringere Leistungsaufnahme. Die Nutzung einer zusätzlichen Dimension ermöglicht eine höhere Ordnung in der Verbindungsfähigkeit der Komponenten und so neue Möglichkeiten im Aufbau bzw. Design.

Die Begriffe "Wafer" und "Substrat" können synonym verwendet werden. Der Wafer kann Materialien ausgewählt aus der Gruppe bestehend aus monokristallinem Silizium, Polysilizium, Siliziumdioxid, Siliziumcarbid, Siliziumgermanium, Siliziumnitrid, Nitrid, Germanium, Kohlenstoff, Galliumarsenid, Galliumnitrid, Indiumphosphid und/oder Glas umfassen.

Diese Materialien sind in der Halbleiter- und/oder Mikrosystemtechnik besonders einfach und kostengünstig zu bearbeiten und eignen sich ebenfalls gut für eine Massenherstellung. Ebenso sind diese Materialien für ein Dotieren und/oder ein Beschichten besonders geeignet, um in bestimmten Bereichen die gewünschten elektrischen, thermischen und/oder optischen Eigenschaften zu erzielen. Die vorgenannten Materialien bieten vielfältige Vorteile aufgrund der Verwendbarkeit standardisierter Herstellungstechniken, welche für die Integration von weiteren Komponenten ebenfalls besonders geeignet sind.

Hierbei ist Prozessierung zur Herstellung des erfindungsgemäßen Systems besonders einfach. Insbesondere können im Stand der Technik etablierte Bondverfahren eingesetzt werden, um die Wafer miteinander zu verbinden.

Es kann auch bevorzugt sein, dass einzelne Wafer beispielsweise über bekannte Polierverfahren aus der Mikrosystemtechnik abgedünnt werden. Die Abdünnung der Wafer kann vor oder nach dem Bonden durchgeführt werden. Vertikale elektrische Verbindung (Durchkontaktierungen) können ebenfalls entweder vor dem Bonden eingebracht oder nach der Herstellung des Stapels hergestellt werden.

Das Bonden von Wafern beschreibt bevorzugt einen Verfahrensschritt in der Halbleiter- und Mikrosystemtechnik, bei dem zwei Wafer oder Scheiben, z. B aus Silizium, Quarz, Glas und/oder den vorgenannten bevorzugten Materialien, miteinander verbunden werden.

Beim Bonden können vorzugsweise verschiedene Verfahren zum Einsatz kommen. Diese werden auch als Bondprozesse oder Bondverfahren bezeichnet. Bevorzugte Bondprozesse umfassen direktes Bonden, anodisches Bonden, Bondverfahren mit Zwischenschichten, Glas-Frit-Bonden, adhäsives Bonden und/oder selektives Bonden.

Beim direkten Bonden, insbesondere von Silizium-Wafern, werden bevorzugt hydrophile und hydrophobe Oberflächen der Wafer unter hohen Temperaturen in Kontakt gebracht. Vorzugsweise wird dabei der eine Wafer mittig gegen den anderen gepresst, wobei vorteilhafterweise ein erster Kontaktpunkt entsteht. Diese mechanische Verbindung im Kontaktbereich beruht dabei vorzugsweise auf Wasserstoffbrücken und/oder Van-der-Waals-Wechselwirkungen. Der somit verbundene Kontaktbereich wird dabei vorzugsweise auf die übrige Waferfläche(n) ausgedehnt, indem anfangs vorhandene Abstandhalter zwischen diesen Flächen sukzessive entfernt werden. Dabei betragen die Prozesstemperaturen vorzugsweise zwischen 1000 °C und 1200 °C und es wird ein Druck auf die Wafer von beispielsweise der Größenordnung 10 Megapascal (MPa) bis 25 MPa ausgeübt. Das Direkt-Bonden kann vorzugsweise für die Verbindung zweier Silizium-Wafer und/oder Siliziumdioxid-Wafer verwendet werden.

Beim anodischen Bonden findet insbesondere ein Glas mit erhöhter Na+-Ionenkonzentration (bevorzugt positiv geladenen Natriumionen) Verwendung, welches bevorzugt mit einem Silizium-Wafer in Kontakt gebracht wird. Dabei wird eine elektrische Spannung angelegt, welche insbesondere konfiguriert ist, eine negative Polung am Glas zu erzeugen. Somit wird bevorzugt und insbesondere mithilfe einer erhöhten Prozesstemperatur erreicht, dass die Natriumionen (Na+) zur Elektrode diffundieren, wodurch sich bevorzugt eine Raumladungszone an der Grenzfläche ausbildet, welches eine Erhöhung des elektrischen Feldes bewirkt und Si-O-Si-Bindungen erzeugt. Diese Bindungen weiten sich bevorzugt sukzessive auf die gesamte Verbindungsfläche zwischen Glas und Silizium aus. Somit können insbesondere Glas und Silizium-Wafer miteinander verbunden werden. Bei entsprechender Anpassung des Prozesses ist ebenso ein Bonden zweier Siliziumlagen und/oder einer Silizium-Metall Lage mit einem Glas möglich. Das anodische Bonden kann vorzugsweise bei Temperaturen von etwa 400 °C stattfinden, es kann ebenso bevorzugt bei "Niedrigtemperatur" bei etwa 180 °C stattfinden, wobei die zu bondenden Materialien vorzugsweise geschont werden. Bevorzugt können auch verschiedene der vorgenannten Materialien gebonded werden.

Bevorzugt können auch Bond-Verfahren mit sogenannten Zwischenschichten zwischen den zu bondenden Wafern zum Einsatz kommen, wie bspw. das sogenannte Eutektische Bonden, welches vorzugsweise auf der Verbindung durch eine eutektische Legierung als Zwischenschicht, z. B. Si-Au (Silizium-Gold) oder Ge-Al (Germanium-Aluminium), basiert. Eine eutektische Legierung ist vorzugsweise eine Legierung, deren Bestandteile in einem solchen Verhältnis zueinander gemischt sind, dass bei einer bestimmten Temperatur die ganze Legierung flüssig bzw. fest wird. Eutektisches Bonden kann z. B. zum Verbinden zweier Silizium-Wafer verwendet werden. Bevorzugt können jedoch auch andere der vorgenannten Materialien verbunden werden.

Auch das Glas-Frit-Bonden beruht bevorzugt auf der Verwendung einer Zwischenschicht zwischen den zu verbindenden Wafern, wobei die Verbindungsbildung insbesondere durch Aufschmelzen von Glasloten/Glas-Fritten. Glaslot umfasst bevorzugt ein Glas, welches eine niedrige Erweichungstemperatur aufweist, bspw. ca. 400 °C. Glas-Fritten umfasst bevorzugt oberflächlich geschmolzenes Glaspulver, dessen Glaskörner bevorzugt zumindest teilweise zusammenbacken bzw. -sintern. Diese Art des Bondens kann bevorzugt Silizium- und/oder Siliziumdioxidwafer miteinander verbinden, bevorzugt jedoch auch andere vorgenannte Materialien.

Das adhäsive Bonden beschreibt bevorzugt eine Verbindungsbildung durch eine Zwischenschicht umfassend Klebstoff. Durch adhäsives Bonden können vorzugsweise verschiedene der vorgenannten Materialien miteinander gebonded werden.

Bevorzugt kann durch Fotolithographie, Ätzen und/oder Lift-off-Verfahren ein selektives Bonden vorgenommen werden.

Das Bonden von Strukturen aus vorbearbeiteten Wafern erlaubt die einfache Herstellung komplexer Strukturen, welche nur mit großem Aufwand aus einem einzelnen Wafer hergestellt werden könnten. Dadurch kann das Halbleiterbauteil hergestellt werden, ohne dass das Rohmaterial aufwendig aus dem Inneren herausgearbeitet werden muss, um die Dämpfungsmembran an einem Wafer bereitzustellen.

In einem weiteren Aspekt betrifft die Erfindung die Verwendung des erfindungsgemäßen Systems für Aeroakustikmessungen, vorzugsweise zur Messung von Schalldruckwellen an Oberflächen eines Fahrzeugbauteiles.

Insbesondere bei Messungen für oder in Flugzeugen, Flugzeugbauteilen, Fahrzeugen wie Automobilsystemen und/oder Automobilkomponenten, können die Schallgrößen sehr hohe Werte annehmen, insbesondere hinsichtlich des Schalldruckpegels. Vorteilhafterweise ermöglicht das erfindungsgemäße System die Messung solch hoher Werte, insbesondere für Messungen hinsichtlich hoher Schalldruckpegel.

Durch das Dämpfungselement bzw. durch die Dämpfungsmembran wird insbesondere der Schalldruckpegel auf einen messbaren Bereich verschoben. Dies wird dadurch erreicht, dass die Dämpfungsmembran ebenfalls in Schwingungen versetzt wird wie die Mikrofonmembran. Insbesondere erfolgt die Verschiebung auf einen messbaren Bereich im Wesentlichen unverzerrt und ohne Verlust des Signal-Rausch-Verhältnisses. Die Dämpfungsmembran und die Mikrofonmembran zeigen im Wesentlichen ein gleiches Schwingungsverhalten auf, wobei sie sich bevorzugt in ihrer Amplitude und in ihrer Phase unterscheiden. Die Phasenverschiebung kommt zustande, da die Dämpfungsmembran zuerst in Schwingungen bevor die Mikrofonmembran in Schwingungen versetzt wird. Durch die Dämpfungsmembran können über die Schwingungen mindestens ca. 10 dB, ca. 20 dB, ca. 30 dB oder mehr an Schalldruckpegel verschoben werden, sodass das das erfindungsgemäße System bei sehr hohen Schalldruckpegeln, wie z.B. bei ca. 180 dB, einsatzfähig ist. Solch hohe Schalldruckpegel werden insbesondere erreicht, wenn eine hohe Relativgeschwindigkeit hinsichtlich eines umströmenden Fluids vorliegt, beispielsweise hohe Strömungs- und/oder Windgeschwindigkeiten.

Durch die geringe Dimensionierung des erfindungsgemäßen Systems wird vorteilhafterweise die Strömung des Fluids nicht und nur sehr gering beeinflusst, sodass vorteilhafterweise kleine laterale Auflösungen von hohen Schallgrößen wie der Schalldruckpegel ermöglicht werden.

Zudem weist das erfindungsgemäße System eine im Wesentlichen planare Bauweise auf, sodass es sehr einfach und effizient an Oberflächen integrierbar ist. Es ist beispielsweise denkbar, dass das erfindungsgemäße System an Flugzeugkomponenten wie z. B. dem Höhenruder, Querruder, etc. einzubauen.

Das erfindungsgemäße System ist in der Handhabung, der Fertigungsstellung und der Weiterverarbeitung sehr einfach, effizient und hat sich als sehr vorteilhaft erwiesen.

Das erfindungsgemäße System soll im Folgenden anhand von Beispielen näher erläutert werden, ohne auf diese Beispiele beschränkt zu sein.

### FIGUREN

### Kurzbeschreibung der Figuren

- **Fig. 1**: Darstellung einer bevorzugten Ausführungsform des erfindungsgemäßen Systems durch Anbringen der Dämpfungsmembran in einen Interposer
- **Fig. 2**: Darstellung einer bevorzugten Ausführungsform des erfindungsgemäßen Systems durch Anbringen auf einem Schaltungsträger
- **Fig. 3**: Darstellung einer bevorzugten Ausführungsform des erfindungsgemäßen Systems durch Anbringen auf einem Schaltungsträger und der Befüllung des Zwischenraumes mit einem Füllmaterial
- **Fig. 4**: Darstellung einer bevorzugten Ausführungsform des erfindungsgemäßen Systems durch Anbringen der Dämpfungsmembran an einer Kavität eines Schaltungsträgers
- **Fig. 5**: Darstellung einer bevorzugten Ausführungsform des erfindungsgemäßen Systems durch Anbringen der Dämpfungsmembran in einer Mikrofonabdeckung
- **Fig. 6**: Darstellung einer weiteren bevorzugten Ausführungsform des erfindungsgemäßen Systems durch Anbringen der Dämpfungsmembran in eine Mikrofonabdeckung in einer Top-Port-Ausführung
- **Fig. 7**: Darstellung einer weiteren bevorzugten Ausführungsform des erfindungsgemäßen Systems durch Anbringen der Dämpfungsmembran in eine Mikrofonabdeckung in einer Bottom-Port-Ausführung
- **Fig. 8**: Darstellung einer weiteren bevorzugten Ausführungsform des erfindungsgemäßen Systems in einem Waferstack
- **Fig. 9**: Darstellung einer Modellierung der Dämpfung durch das erfindungsgemäße System

### Detaillierte Beschreibung der Figuren

**Fig. 1** ist eine Darstellung eines bevorzugten Systems **1.** Hierbei ist in einen Interposer **15** eine Dämpfungsmembran **11** eingebracht. Die Dämpfungsmembran **11** wird durch das Bilden einer Kavität **17** in den Interposer **15** angebracht. Die Kavität **17** kann über im Stand der Technik etablierte und bekannte Ätzprozesse gebildet werden, die weiter oben aufgezählt und beschrieben worden sind. Die Dämpfungsmembran **11** am Interposer **15** wird vor einer Schalleintrittsöffnung **5** eines MEMS-Mikrofons **3** angebracht. Für aeroakustische Anwendungen oder Messungen befindet sich die Schalleintrittsöffnung **5** in Fließrichtung der Luft. Zur mechanischen und/oder elektrischen Kontaktierung befinden sich am Inteposer **15** und/oder am MEMS-Mikrofon **3** ein Lötring **19** und ein Metallpad **31.** Das MEMS-Mikrofon 3 weist eine elektronische Schaltung **9** auf, die beispielsweise in Form eine ASICs vorliegen kann (gekennzeichnet durch den Begriff ASIC), ein Gehäuse **13** und eine schwingfähige Mikrofonmembran **7.** Schall kann durch die Schalleintrittsöffnung **5** treten und zur Mikrofonmembran **7** gelangen. Beim Eintreffen von Schallwellen wird die Mikrofonmembran **7** angeregt und in Schwingungen versetzt.

Durch die elektronische Schaltung **5** wird ein von den Schallwellen abhängiges elektrisches Signal erzeugt, wobei Schallgrößen der Schallwellen gemessen und/oder ermittelt werden können. Bei den im Stand der Technik bekannten MEMS-Mikrofonen ist es nicht möglich, hohe Schalldruckpegel zu messen, die beispielsweise bei ca. 175 dB liegen. Die Mikrofonmembran der bereits bekannten MEMS-Mikrofonen ist für so hohe Schalldruckpegel nicht ausgelegt. Um solch hohe Schalldruckpegel messen zu können, ist die Dämpfungsmembran **11** angebracht, die ebenfalls in Schwingungen versetzt wird, wenn Schallwellen diese treffen.

Die Dämpfungsmembran **11** bzw. der Interposer **15** umfasst ein Material, welches elastisch verformbar, aber nicht plastisch verformbar, ist, z. B. Silizium, Siliziumoxid, Siliziumnitrid, Glas, Keramik oder anders organisches Material, wobei in der **Fig. 1** die blaue Farbe Silizium darstellen soll. Hierdurch kann die Dämpfungsmembran **11** und die Mikrofonmembran **7** ein im Wesentlichen gleiches Schwingungsverhalten aufweisen. Dies ist von großem Vorteil, da durch Schwingungen der Dämpfungsmembran **11** der Schalldruckpegel unverzerrt auf einen für die Mikrofonmembran **7** messbaren Bereich verschoben wird.

Insbesondere bleibt das Signal-Rausch-Verhältnis des gemessenen Signals erhalten. Hierbei können Schalldruckpegel hinsichtlich des Betrages um mindestens 10 dB, mindestens 20 dB oder mindestens 30 dB reduziert werden. Dies erfolgt durch eine Aufteilung der Schallenergie der Schallwellen auf Schwingungen der Dämpfungsmembran **11** und der Mikrofonmembran **7.** Zudem ist ein weiterer großer Vorteil des erfindungsgemäßen Systems **1,** dass es eine geringe Dimensionierung aufweist. Hierdurch wird das Strömungsverhalten der umströmten Luft im Wesentlichen nicht oder nur geringfügig beeinflusst, sodass genaue und unverfälschte Messergebnisse erhalten werden können. Des Weiteren weist das erfindungsgemäße System **1** eine planare Ausgestaltung auf, sodass es sich besonders einfach und effizient auf Oberflächen integrieren lässt. Zudem bildet das erfindungsgemäße System 1 ein geschlossenes System, sodass besonders einfach Schmutzpartikel entfernt und insbesondere nicht eintreten können. Hierdurch erhöht sich vorteilhafterweise die gesamtheitliche Bauteilqualität.

C**Fig. 2 A-B** zeigt eine Darstellung einer weiteren bevorzugten Ausführungsform des erfindungsgemäßen Systems **1.** Hierbei wird das erfindungsgemäße System **1** auf einen Schaltungsträger **25** angebracht. Die **Fig. 2** **A** zeigt das erfindungsgemäße System **1** vor dem Anbringen an den Schaltungsträger **25.** Die **Fig. 2** **B** zeigt das erfindungsgemäße System **1,** welches nun an den Schaltungsträger **25** montiert ist. Der Schaltungsträger kann beispielsweise eine PCB-Leiterplatte sein.

Das erfindungsgemäße System **1** wird derart an den Schaltungsträger **25** platziert, dass sich das MEMS-Mikrofon **3** innerhalb einer Kavität **27** des Schaltungsträgers befindet, wobei sich ein Zwischenraum **29** zwischen dem MEMS-Mikrofon **3,** dem Interposer **15** und/oder dem Schaltungsträger **25** bilden kann. Die Kavität **27** bietet einen optimalen Schutz für das MEMS-Mikrofon. Innerhalb der Kavität sitzt das MEMS-Mikrofon **3** besonders stabil, robust und fest, sodass bei Beanspruchungen, beispielsweise durch Verschiebungen, die durch hohe Fließgeschwindigkeiten der Luft entstehen könnten, es zu keinen Beschädigungen der inneren Komponenten des MEMS-Mikrofons **3** kommt. Weiterhin kann auf diese Weise eine sehr kompakte Bauweise erzielt werden, welche eine Integration der MEMS-Mikrofone in eine Oberfläche erleichtern. Zudem werden Leitungswege verkürzt und eine effiziente Übertragung elektrischer Signale gewährleistet.

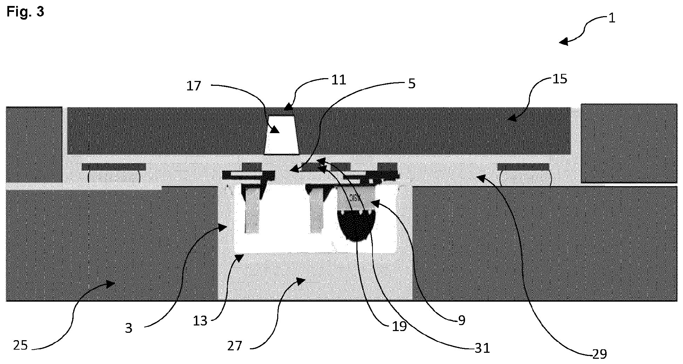

**Fig. 3** zeigt eine Darstellung einer bevorzugten Ausführungsform mit einer Befüllung des Zwischenraumes **29** mit einem Füllmaterial. Das Füllmaterial kann einen oder mehrere Polymere, vorzugsweise ein oder mehrere zyklische, lineare, verzweigte und/oder vernetzte Polysiloxane, umfassen. Durch die Befüllung des Zwischenraumes mit einem Füllmaterial wird eine besonders hohe Stabilisierung und ein rückseitiger Abschluss des erfindungsgemäßen Systems 1 erreicht. Zudem wird durch das Füllmaterial bevorzugt ein Mitschwingen des Interposers und/oder des Schaltungsträgers weitestgehend verhindert. Zur Verschiebung des Schalldruckpegels auf einen messbaren Bereich wird bevorzugt nur die Dämpfungsmembran in Schwingungen versetzt, also insbesondere der Bereich über der Schalleintrittsöffnung.

**Fig. 4 A-B** zeigt eine Darstellung einer bevorzugten Ausführungsform des erfindungsgemäßen Systems durch Anbringen der Dämpfungsmembran **11** an der Kavität **27** des Schaltungsträgers **25.** Hierbei wird in **Fig. 4** **A** zunächst die Dämpfungsmembran **11** über der Schalleintrittsöffnung 5 des MEMS-Mikrofons **3** angebracht. Das Anbringen kann über Bond-, Klebe- und/oder Lötprozesse erfolgen. In **Fig. 4** **B** wird dieses so in den Schaltungsträger **25** platziert, dass die Dämpfungsmembran sich innerhalb der Kavität **27** befindet. Diese Ausführungsform ist insbesondere in der SMD-Technologie (engl. surface-mounted device) relevant. Während die Anschlussdrähte konventioneller Bauelemente durch Bestückungslöcher geführt werden und auf der Rückseite der Leiterplatte (oder über Innenlagen) verlötet werden müssen, entfällt dies in der SMD-Technologie bzw. in SMD-Bauteilen. Dadurch werden sehr dichte Bestückungen und vor allem eine beidseitige Bestückung der Leiterplatte möglich. Die elektrischen Eigenschaften der Schaltungen werden speziell bei höheren Frequenzen positiv beeinflusst. Des Weiteren verringert sich der Platzbedarf der Bauelemente.

**Fig. 5** zeigt eine Darstellung einer bevorzugten Ausführungsform des erfindungsgemäßen Systems **1** durch Anbringen der Dämpfungsmembran **11** an einer Mikrofonabdeckung **21.** Hierbei kann die Mikrofonabdeckung **21** selbst als Dämpfungsmembran wirken. Dies bedeutet, dass die Mikrofonabdeckung **21** selbst in Schwingungen versetzt wird, wenn Schallwellen aufkommen und damit der Schalldruckpegel verschoben werden kann, beispielsweise um ca. 20 dB. Es kann auch sein, dass nur ein Bereich über der Schalleintrittsöffnung **5** in Schwingungen versetzt wird, die Dämpfungsmembran **11,** sodass der Schalldruckpegel unverzerrt auf einen für die Mikrofonmembran **7** messbaren Bereich zu verschieben. An der Mikrofonabdeckung **21** können sich Öffnungen **23** befinden, die für einen Druckausgleich zwischen dem erfindungsgemäßen System **1** und seiner Umgebung führen. Insbesondere sind zwei erfindungsgemäße Systeme **1** auf einem Schaltungsträger **25.** Das erfindungsgemäße System **1** kann somit auch als Array ausgestaltet sein um beispielsweise in der Aeroakustik eine hochauflösende Schallmessung zu ermöglichen.

**Fig. 6** zeigt eine Darstellung einer weiteren bevorzugten Ausführungsform des erfindungsgemäßen Systems durch Anbringen einer Mikrofonabdeckung **21** über einem MEMS-Mikrofon in einer Top-Port-Ausführung. Hierbei trifft der Schall über eine Gehäuseoberseite auf die Mikrofonmembran **7.** Insbesondere liegt im Rückvolumen von Top-Port-Ausführungen eines MEMS-Mikrofons **3** ein kleineres Luftvolumen vor als das Vorvolumen. Die Mikrofonabdeckung **21** kann in Form eines Deckels und/oder eine Folie vorliegen, die aus einem elastischen Material gebildet ist. Bevorzugt kann nur ein Bereich der Mikrofonabdeckung **21** über der Schalleintrittsöffnung **5** schwingen, oder aber weitere laterale Bereiche oder die gesamte Fläche schwingen, um den Schalldruckpegel aus messbare Bereiche der Mikrofonmembran 7 zu dämpfen.

**Fig. 7** zeigt eine ähnliche Darstellung wie in **Fig. 6****,** allerdings liegt in **Fig. 7** eine Bottom-Port-Ausführung des MEMS-Mikrofons **3** vor. In Bottom-Port-Mikrofonen wird die Mikrofonmembran meist direkt über der Schalleintrittsöffnung **5** angeordnet, was eine Reihe von Vorteilen bietet. Insbesondere liegt im Rückvolumen von Bottom-Port-Ausführungen eines MEMS-Mikrofons 3 ein größeres Rückvolumen vor als im Vorvolumen. Ein großes Luftvolumen im Rückvolumen erleichtert es der Mikrofonmembran **7,** sich unter dem Einfluss der Schallwellen zu bewegen. Dies wiederum verbessert die Empfindlichkeit und den Signal-Rausch-Abstand des MEMS-Mikrofons **3.** Von einem Rückvolumen profitiert auch das Ansprechverhalten des MEMS-Mikrofons **3** auf niedrige Frequenzen.

**Fig. 8** zeigt eine Darstellung einer weiteren bevorzugten Ausführungsform des erfindungsgemäßen System innerhalb eines Waferstacks. Das MEMS-Mikrofon **3** umfassend der Mikrofonmembran 7 in einem ersten Wafer **33** und die Dämpfungsmembran **11** in einem zweiten Wafer **35.** Hierbei wird die Dämpfungsmembran **11** durch Bilden einer Kavität in den zweiten Wafer **35** bereitgestellt. **Fig. 8** **A** zeigt die beiden Wafer **33** und **35** vor dem Bonden und **die** **Fig. 8** **B** zeigt die beiden Wafer **33** und **35** nachdem sie miteinander zu einem Waferstack gebondet werden. Insbesondere wird in dieser Darstellung gezeigt, dass entlang des erstem Wafers **33** ein Array auf MEMS-Mikrofonen **3** gebildet werden kann und entlang des zweiten Wafers **35** ein Array aus Dämpfungsmembranen **11.** Hierbei ist die Prozessierung zur Herstellung des Waferstacks besonders einfach. Insbesondere können im Stand der Technik etablierte Bondverfahren eingesetzt werden, um die Wafer **33** und **35** miteinander zu verbinden.

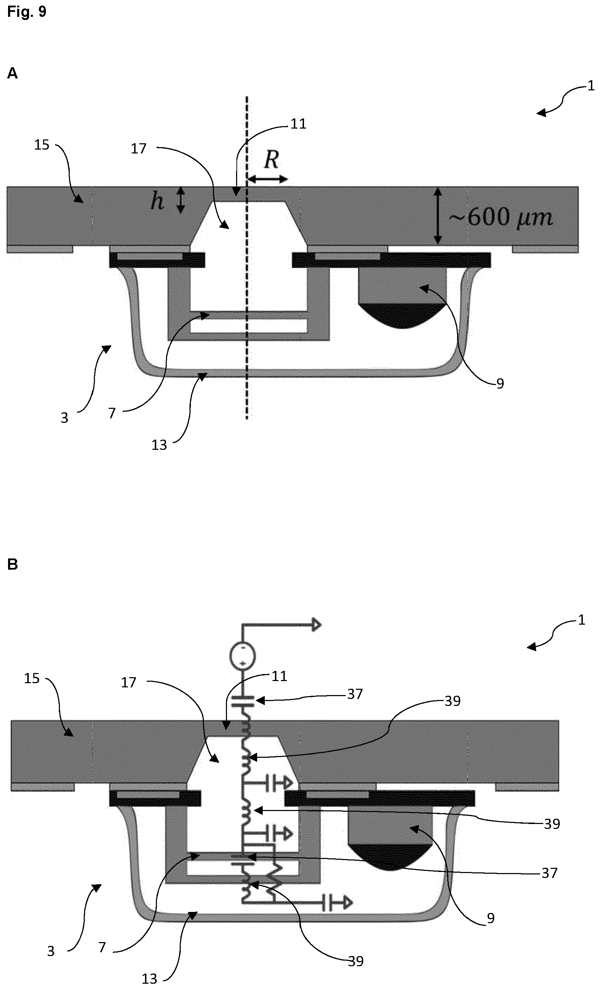

**Fig. 9 A-D** zeigt eine bevorzugte Ausführungsform des erfindungsgemäßen Systems **1** mit einer Modellierung im Rahmen eines Ersatzschaltbildes und Simulationsergebnisse hinsichtlich einiger Parameter der Dämpfungsmembran **11.**

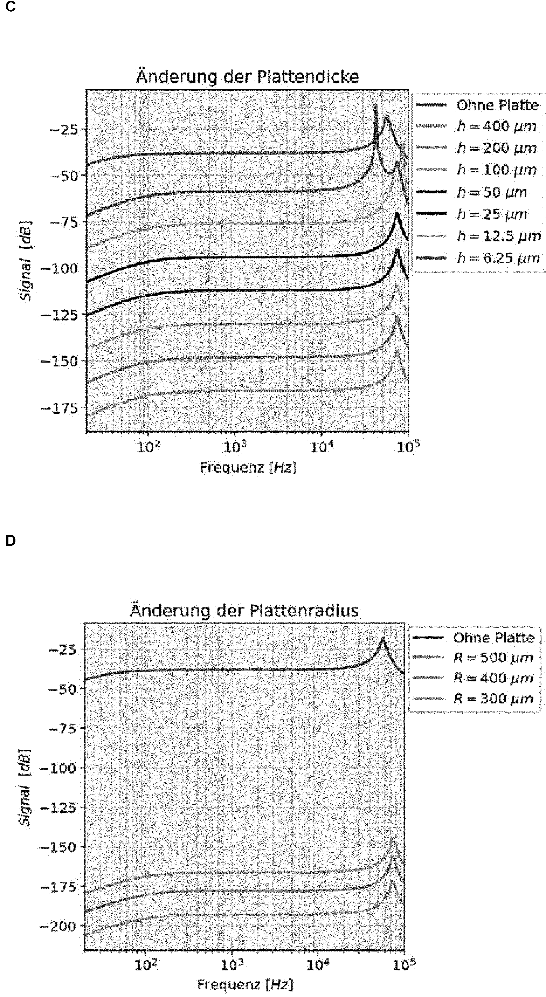

**Fig. 9** **A** zeigt eine bevorzugte Ausführungsform des erfindungsgemäßen Systems **1.** An dem Interposer **15** wird die Kavität **17** angebracht, sodass die Dämpfungsmembran **11** am Interposer **15** gebildet wird. Die Dämpfungsmembran kann hohe Schalldruckpegel unter Erhalt der Bandbreite auf für die Mikrofonmembran **7** messbare Bereiche verschieben, beispielsweise durch eine Verschiebung um mindestens ca. 10 dB, mindestens ca. 20 dB oder mindestens ca. 30 dB oder mehr. Dies erfolgt durch eine Aufteilung der Schallenergie auf Schwingungen der Mikrofonmembran **7** und der Dämpfungsmembran **11.** Eine Höhe **h** bezeichnet die Höhe bzw. die Dicke der Dämpfungsmembran **11** und ein Parameter **R** dessen Radius.

**Fig. 9** **B** stellt die gleiche Ausführungsform in **Fig. 9** **A** dar, allerdings mit einem zusätzlichen Ersatzschaltbild, welches für eine Modellierung des erfindungsgemäßen Systems **1** genutzt wird. Ganz oben im Schaltbild ist eine Spannungsquelle zur Einspeisung elektrischer Energie eingezeichnet, was im erfindungsgemäßen Kontext einer Schallwelle zur Einspeisung von Schallenergie entspricht. Die Spannungsquelle liefert Strom, die an einem Kondensator 37, z. B einen Plattenkondensator, geführt wird. Der Kondensator **37** entspricht der Dämpfungsmembran **11** des erfindungsgemäßen Systems. Beim Auftreffen von Schallwellen wird die Dämpfungsmembran **11** ausgelenkt und in Schwingungen versetzt, wodurch die Dämpfungsmembran Schallenergie aufnimmt, analog zur Speicherung elektrischer Energie in einem Plattenkondensator **37.** Die Kavität **17** und das Vorvolumen können durch eine oder mehreren Spulen, die hintereinander verschaltet sind, moduliert werden. Auch das Luftvolumen im Rückvolumen ist ein zu berücksichtigender Faktor, der ebenfalls durch eine Spule **39** modelliert werden kann, wobei die Mikrofonmembran **7** und eine Rückwand ebenfalls durch Kondensatoren **37** in dem Schaltbild moduliert werden können.

Wie eine Modellierung des akustischen Systems anhand des elektronischen Schaltbildes zeigt, ist das Schwingungsverhalten und damit die Reduktionsfähigkeit der Schalldruckpegeln von einigen Parametern abhängig. Dies wird in den **Fig. 9** **C** und **9 D** deutlich.

Für **die** **Fig. 9** **C** wurde für die Simulation die Dicke der Dämpfungsmembran bzw. die Plattendicke h variiert, der Radius R aber konstant gehalten. Auf der y-Achse ist der Schalldruckpegel in negativen dB-Angaben und auf der x-Achse die Frequenz in einer logarithmischen Darstellung gegeben. Die Simulationsergebnisse verdeutlichen, dass über einen breiten Frequenzbereich eine gleichmäßige, verzerrungsfreie Reduktion des Schalldruckpegels möglich ist.

Weiterhin zeigen die Ergebnisse, dass durch eine Wahl der Plattendicke gezielt eine gewünschte Reduktion des Schalldruckpegels eingestellt werden kann. Insbesondere ist die Reduktion des Schalldruckpegel umso höher, je höher die die Plattendicke h (die Dicke der Dämpfungsmembran) ist. Gegenüber dem Fall ohne Dämpfungsmembran, kann eine Dämpfungsmembran mit einer Plattendicke h von beispielsweise ca. 6,25 µm den Schalldruckpegel von ca. -40 dB (ohne Platte) auf ca. -60 dB absenken. Eine Plattendicke von ca. 200 µm schafft über weite Frequenzbereiche eine Absenkung auf einen Schalldruckpegel von ca. -150 dB.

In **Fig. 9 d** wird die gleiche Simulation durchgeführt, allerdings wird nun die Plattendick **h** konstant bei 400 µm gehalten, während der Radius **R** der Platte bzw. Dämpfungsmembran **11** variiert wird, was der lateralen Erstreckung der Dämpfungsmembran **11** entspricht. Auch durch eine Wahl des Radius der Dämpfungsmembran kann gezielt eine gewünschte Reduktion des Schalldruckpegels eingestellt werden kann. Insbesondere ist die Reduktion Schalldruckpegel umso höher, je kleiner der Radius der Dämpfungsmembran ist.

Bei einem Radius von ca. 500 µm - welche nahezu der Schalleintrittsöffnung entspricht - liegt das Signal über einen weiten Frequenzbereich von 100 Hz -10 kHz bei ca. -165 dB, während ein Radius von ca. 300 µm dies auf ca. -200 dB senkt.

### BEZUGSZEICHENLISTE

- 1: System
- 3: MEMS-Mikrofon
- 5: Schalleintrittsöffnung
- 7: Mikrofonmembran
- 9: Elektronische Schaltung (z. B. ASIC)
- 11: Dämpfungsmembran
- 13: Gehäuse
- 15: Interposer
- 17: Kavität im Interposer
- 19: Lötring
- 21: Mikrofonabdeckung
- 23: Öffnung in der Mikrofonabdeckung
- 25: Schaltungsträger
- 27: Kavität im Schaltungsträger
- 29: Zwischenraum
- 31: Metallpad
- 33: Erster Wafer
- 35: Zweiter Wafer
- 37: Kondensator
- 39: Spule
- h: Höhe der Dämpfungsmembran bzw. Plattendicke
- R: Radius der Dämpfungsmembran

### LITERATURVERZEICHNIS

Martin, David T., et al. "A micromachined dual-backplate capacitive microphone for aeroacoustic measurements." Journal of Microelectromechanical Systems 16.6 (2007): 1289-1302.

Sheplak, Mark, et al. "A MEMS microphone for aeroacoustics measurements." 37th Aerospace Sciences Meeting and Exhibit. 1999.

Horowitz, Stephen, et al. "Development of a micromachined piezoelectric microphone for aeroacoustics applications." The Journal of the Acoustical Society of America 122.6 (2007): 3428-3436.

## Patentansprüche

1. System (1) umfassend
a) ein MEMS-Mikrofon (3) umfassend eine Schalleintrittsöffnung (5), eine schwingfähige Mikrofonmembran (7) und eine elektronische Schaltung (9), wobei bei einer Anregung der Mikrofonmembran (7) zu Schwingungen durch Schallwellen, welche durch die Schalleintrittsöffnung (5) treten, ein von den Schallwellen abhängiges elektrisches Signal erzeugt wird und
b) ein Dämpfungselement zur Reduktion eines an der Mikrofonmembran (7) wirkenden Schalldruckpegels der Schallwellen
wobei das Dämpfungselement eine elastische und schwingfähige Dämpfungsmembran (11) umfasst, welche vor der Schalleintrittsöffnung (5) angebracht vorliegt und zusätzlich zur Mikrofonmembran (7) durch die Schallwellen zu Schwingungen angeregt wird, sodass eine Schallenergie der Schallwellen zwischen der Dämpfungsmembran (11) und der Mikrofonmembran (7) aufgeteilt wird,
**dadurch gekennzeichnet, dass**
die Aufteilung der Schallenergie der einfallenden Schallwellen auf die Dämpfungsmembran (11) und die Mikrofonmembran (7) zu einer Reduktion des an der Mikrofonmembran (7) wirkenden Schalldruckpegels um mindestens 10 dB führt und wobei das System (1) einen Interposer (15) umfasst und die Dämpfungsmembran (11) in dem Interposer (15) eingebracht vorliegt.

2. System (1) nach dem vorherigen Anspruch
**dadurch gekennzeichnet, dass**
eine Aufteilung der Schallenergie der einfallenden Schallwellen auf die Dämpfungsmembran (11) und die Mikrofonmembran (7) zu einer Reduktion des an der Mikrofonmembran (7) wirkenden Schalldruckpegels um mindestens 20 dB, bevorzugt um mindestens 30 dB führt.

3. System (1) nach einem oder mehreren der vorherigen Ansprüche
**dadurch gekennzeichnet, dass**
die Dämpfungsmembran (11) aus einem elastischen Material gebildet wird, vorzugsweise ausgewählt aus einer Gruppe umfassend monokristallines Silizium, Polysilizium, Siliziumdioxid, Siliziumnitrid, Siliziumcarbid, Siliziumgermanium, Siliziumnitrid, Nitrid, Germanium, Kohlenstoff, Galliumarsenid, Galliumnitrid, Indiumphosphid, Glas und/oder einem Metall.

4. System (1) nach einem oder mehreren der vorherigen Ansprüche
**dadurch gekennzeichnet, dass**
die Dämpfungsmembran (11) eine Dicke von 50 nm bis 500 µm, bevorzugt 100 nm bis 200 µm, besonders bevorzugt 1 µm bis 50 µm aufweist und/oder
die Dämpfungsmembran (11) sich mindestens über die Schalleintrittsöffnung (5) erstreckt und/oder die Dämpfungsmembran (11) eine laterale Ausdehnung von 100 µm bis 2000 µm, vorzugsweise 200 µm bis 1000 µm aufweist.

5. System (1) nach einem oder mehreren der vorherigen Ansprüche
**dadurch gekennzeichnet, dass**
das MEMS-Mikrofon (3) in einer Top-Port- oder Bottom-Port-Ausführung vorliegt und/oder innerhalb eines mehrlagigen Substrates, vorzugweise eines Waferstacks, integriert vorliegt und/oder
das MEMS-Mikrofon (3) ein kapazitives, piezoelektrisches und/oder piezoresistives MEMS-Mikrofon (3) und/oder ein Elektretmikrofon ist.

6. System (1) nach einem oder mehreren der vorherigen Ansprüche
**dadurch gekennzeichnet, dass**
die Dämpfungsmembran (11) durch Einbringen einer Kavität (17) in dem Interposer (15) gebildet, wobei bevorzugt eine Tiefe der Kavität (17) derart gewählt wird, dass die in dem Interposer (15) gebildete Dämpfungsmembran (11) eine Dicke von 50 nm bis 500 µm, bevorzugt 100 nm bis 200 µm, besonders bevorzugt 1 µm bis 50 µm aufweist und/oder eine laterale Ausdehnung von 100 µm bis 2000 µm, vorzugsweise 200 µm bis 1000 µm aufweist.

7. System (1) nach einem oder mehreren der vorherigen Ansprüche
**dadurch gekennzeichnet, dass**
der Interposer (15) eine Dicke bis zu 1000 µm, bevorzugt bis zu 700 µm, besonders bevorzugt zwischen 400 und 700 µm aufweist und/oder
der Interposer (15) eine elektrische Kontaktierung des MEMS-Mikrofons (3) zu einem Schaltungsträger (25), vorzugweise einer Leiterplatte, vermittelt.

8. System (1) nach einem oder mehreren der vorherigen Ansprüche
**dadurch gekennzeichnet, dass**
eine geschlossene elektrische Verbindung zwischen dem MEMS-Mikrofon (3) und dem Interposer (15), vorzugsweise in Form eines Lötrings (19), um die Schalleintrittsöffnung (5) gebildet wird, welche sowohl eine elektrische Kontaktierung zwischen dem MEMS-Mikrofon (3) und dem Interposer (15) als auch einen akustischen Abschluss vermittelt.

9. System (1) nach einem oder mehreren der vorherigen Ansprüche
**dadurch gekennzeichnet, dass**
die Dämpfungsmembran (11) in einer Mikrofonabdeckung (21) integriert vorliegt bzw. von dieser gebildet wird, wobei die Mikrofonabdeckung (21) optional eine Öffnung (23) für einen Druckausgleich umfasst.

10. System (1) nach einem oder mehreren der vorherigen Ansprüche
**dadurch gekennzeichnet, dass**
das System mindestens zwei Wafer (33, 35) umfasst, welche einen Waferstack bilden, wobei das MEMS-Mikrofon (3) in einem ersten Wafer (33) und die Dämpfungsmembran (11) in einem zweiten Wafer (35) gebildet vorliegt.

11. System (1) nach einem oder mehreren der vorherigen Ansprüche
**dadurch gekennzeichnet, dass**
das MEMS-Mikrofon (3) mit einem Schaltungsträger (25), vorzugsweise einer Leiterplatte, kontaktiert vorliegt, wobei der Schaltungsträger (25), vorzugsweise eine Leiterplatte, eine Kavität (27) zur Aufnahme des MEMS-Mikrofons (3) aufweist.

12. System (1) nach einem oder mehreren der vorherigen Ansprüche
**dadurch gekennzeichnet, dass**
ein Zwischenraum (29) zwischen dem MEMS-Mikrofon (3), einem Interposer (15) und/oder einem Schaltungsträger (25), vorzugsweise einer Leiterplatte, mit einem Füllmaterial befüllt wird.

13. System (1) nach dem vorherigen Anspruch
**dadurch gekennzeichnet, dass**
das Füllmaterial einer oder mehrere Polymere, vorzugsweise ein oder mehrere zyklische, lineare, verzweigte und/oder vernetzte Polysiloxane umfasst.

14. Verwendung eines Systems (1) nach einem oder mehreren der vorherigen Ansprüche für Aeroakustikmessungen, vorzugsweise zur Messung von Schalldruckwellen an Oberflächen eines Fahrzeugbauteiles.

## Claims

1. System (1) comprising
a) a MEMS microphone (3) comprising a sound inlet opening (5), a vibratable microphone membrane (7) and an electronic circuit (9), wherein when the microphone membrane (7) is induced into vibrations by sound waves entering through the sound inlet opening (5), an electrical signal that is dependent on the sound waves is generated, and
b) a damping element for reducing a sound pressure level of the sound waves acting on the microphone membrane (7)
wherein the damping element comprises an elastic and vibratable damping membrane (11), which is mounted in front of the sound inlet opening (5) and, in addition to the microphone membrane (7), is induced into vibrations by the sound waves, such that sound energy of the sound waves is divided between the damping membrane (11) and the microphone membrane (7),
**characterized in that**
the division of the sound energy of the incident sound waves to the damping membrane (11) and the microphone membrane (7) leads to a reduction of the sound pressure level acting on the microphone membrane (7) by at least 10 dB and wherein the system (1) comprises an interposer (15) and the damping membrane (11) is located in the interposer (15).

2. System (1) according to the preceding claim
**characterized in that**
dividing the sound energy of the incident sound waves between the damping membrane (11) and the microphone membrane (7) leads to a reduction in the sound pressure level acting on the microphone membrane (7) by at least 20 dB, preferably by at least 30 dB.

3. System (1) according to one or more of the preceding claims
**characterized in that**
the damping membrane (11) is formed from an elastic material, preferably selected from a group comprising monocrystalline silicon, polysilicon, silicon dioxide, silicon nitride, silicon carbide, silicon germanium, silicon nitride, nitride, germanium, carbon, gallium arsenide, gallium nitride, indium phosphide, glass and/or a metal.

4. System (1) according to one or more of the preceding claims
**characterized in that**
the damping membrane (11) exhibits a thickness of 50 nm to 500 µm, preferably 100 nm to 200 µm, particularly preferably 1 µm to 50 µm and/or
the damping membrane (11) extends at least over the sound inlet opening (5) and/or the damping membrane (11) exhibits a lateral extension of 100 µm to 2000 µm, preferably 200 µm to 1000 µm.

5. System (1) according to one or more of the preceding claims
**characterized in that**
the MEMS microphone (3) is present in a top-port or bottom-port design and/or is integrated within a multilayer substrate, preferably a wafer stack, and/or
the MEMS microphone (3) is a capacitive, piezoelectric and/or piezoresistive MEMS microphone (3) and/or an electret microphone.

6. System (1) according to one or more of the preceding claims
**characterized in that**
the damping membrane (11) is formed by introducing a cavity (17) in the interposer (15), wherein preferably a depth of the cavity (17) is selected such that the damping membrane (11) formed in the interposer (15) has a thickness of 50 nm to 500 µm, preferably 100 nm to 200 µm, particularly preferably 1 µm to 50 µm and/or has a lateral extension of 100 µm to 2000 µm, preferably 200 µm to 1000 µm.

7. System (1) according to one or more of the preceding claims
**characterized in that**
the interposer (15) has a thickness of up to 1000 µm, preferably up to 700 µm, particularly preferably between 400 and 700 µm and/or
the interposer (15) provides an electrical contact between the MEMS microphone (3) and a circuit carrier (25), preferably a printed circuit board.

8. System (1) according to one or more of the preceding claims
**characterized in that**
a closed electrical connection is formed between the MEMS microphone (3) and the interposer (15), preferably in the form of a solder ring (19), around the sound inlet opening (5), which provides both an electrical contact between the MEMS microphone (3) and the interposer (15) and an acoustic seal.

9. System (1) according to one or more of the preceding claims
**characterized in that**
the damping membrane (11) is integrated in or formed by a microphone cover (21), the microphone cover (21) optionally comprising an opening (23) for pressure equalization.

10. System (1) according to one or more of the preceding claims
**characterized in that**
the system comprises at least two wafers (33, 35) forming a wafer stack, wherein the MEMS microphone (3) is present in a first wafer (33) and the damping membrane (11) is formed in a second wafer (35).

11. System (1) according to one or more of the preceding claims
**characterized in that**
the MEMS microphone (3) is in contact with a circuit carrier (25), preferably a printed circuit board, wherein the circuit carrier (25), preferably a printed circuit board, exhibits a cavity (27) for receiving the MEMS microphone (3).

12. System (1) according to one or more of the preceding claims
**characterized in that**
a space (29) between the MEMS microphone (3), an interposer (15) and/or a circuit carrier (25), preferably a printed circuit board, is filled with a filling material.

13. System (1) according to the preceding claim
**characterized in that**
the filling material comprises one or more polymers, preferably one or more cyclic, linear, branched and/or cross-linked polysiloxanes.

14. Use of a system (1) according to one or more of the preceding claims for aeroacoustic measurements, preferably for measuring sound pressure waves on surfaces of a vehicle component.

## Revendications

1. Système (1) comprenant
a) un microphone MEMS (3) comprenant une ouverture d'entrée du son (5), une membrane de microphone vibrante (7) et un circuit électronique (9), dans lequel lorsque la membrane du microphone (7) est excitée pour vibrer par des ondes sonores qui traversent l'ouverture d'entrée du son (5), un signal électrique dépendant des ondes sonores est généré et
b) un élément d'amortissement pour réduire le niveau de pression acoustique des ondes sonores agissant sur la membrane du microphone (7)
dans lequel l'élément d'amortissement comprend une membrane d'amortissement élastique et vibrante (11) qui est montée devant l'ouverture d'entrée du son (5) et, en plus de la membrane du microphone (7), est excitée pour vibrer par les ondes sonores, de sorte qu'une énergie sonore des ondes sonores est répartie entre la membrane d'amortissement (11) et la membrane du microphone (7),
**caractérisé en ce que**
la répartition de l'énergie sonore des ondes sonores incidentes entre la membrane d'amortissement (11) et la membrane du microphone (7) conduit à une réduction du niveau de pression sonore agissant sur la membrane du microphone (7) d'au moins 10 dB et dans lequel le système (1) comprend un interposeur (15) et la membrane d'amortissement (11) est incorporée dans l'interposeur (15).

2. Système (1) selon la revendication précédente
**caractérisé en ce que**
une répartition de l'énergie sonore des ondes sonores incidentes entre la membrane d'amortissement (11) et la membrane du microphone (7) conduit à une réduction du niveau de pression acoustique agissant sur la membrane du microphone (7) d'au moins 20 dB, de préférence d'au moins 30 dB.

3. Système (1) selon une ou plusieurs des revendications précédentes
**caractérisé en ce que**
la membrane d'amortissement (11) est formée d'un matériau élastique, de préférence choisi dans un groupe comprenant du silicium monocristallin, du polysilicium, du dioxyde de silicium, du nitrure de silicium, du carbure de silicium, du silicium-germanium, du nitrure de silicium, du nitrure de germanium, du carbone, de l'arséniure de gallium, du nitrure de gallium, du phosphure d'indium, du verre et/ou un métal.

4. Système (1) selon une ou plusieurs des revendications précédentes
**caractérisé en ce que**
la membrane d'amortissement (11) a une épaisseur de 50 nm à 500 µm, de préférence de 100 nm à 200 µm, de manière particulièrement préférée de 1 µm à 50 µm et/ou
la membrane d'amortissement (11) s'étend au moins sur l'ouverture d'entrée du son (5) et/ou la membrane d'amortissement (11) a une étendue latérale de 100 µm à 2000 µm, de préférence de 200 µm à 1000 µm.

5. Système (1) selon une ou plusieurs des revendications précédentes
**caractérisé en ce que**
le microphone MEMS (3) est de conception à port supérieur ou inférieur et/ou est intégré dans un substrat multicouches, de préférence une pile de wafers et/ou
le microphone MEMS (3) est un microphone MEMS capacitif, piézoélectrique et/ou piézorésistif (3) et/ou un microphone à électret.

6. Système (1) selon une ou plusieurs des revendications précédentes
**caractérisé en ce que**
la membrane d'amortissement (11) est formée en introduisant une cavité (17) dans l'interposeur (15), dans lequel la profondeur de la cavité (17) étant de préférence choisie de telle sorte que la membrane d'amortissement (11) introduite dans l'interposeur (15) ait une épaisseur de 50 nm à 500 µm, de préférence de 100 nm à 200 µm, de manière particulièrement préférée de 1 µm à 50 µm et/ou une étendue latérale de 100 µm à 2000 µm, de manière préférée de 200 µm à 1000 µm.

7. Système (1) selon une ou plusieurs des revendications précédentes
**caractérisé en ce que**
l'interposeur (15) a une épaisseur allant jusqu'à 1000 µm, de préférence jusqu'à 700 µm, de manière particulièrement préférée entre 400 et 700 µm et/ou
l'interposeur (15) assure un contact électrique entre le microphone MEMS (3) et un support de circuit (25), de préférence une carte de circuit imprimé.

8. Système (1) selon une ou plusieurs des revendications précédentes
**caractérisé en ce que**
une connexion électrique fermée est formée entre le microphone MEMS (3) et l'interposeur (15), de préférence sous la forme d'un anneau de soudure (19), autour de l'ouverture d'entrée du son (5), qui fournit à la fois un contact électrique entre le microphone MEMS (3) et l'interposeur (15) et une terminaison acoustique.

9. Système(1) selon une ou plusieurs des revendications précédentes
**caractérisé en ce que**
la membrane d'amortissement (11) est intégrée dans ou formée par un couvercle de microphone (21), dans lequel le couvercle de microphone (21) comprend éventuellement une ouverture (23) pour l'égalisation de pression.

10. Système (1) selon une ou plusieurs des revendications précédentes
**caractérisé en ce que**
le système comprend au moins deux plaquettes (33, 35) qui forment une pile de wafers, dans lequel le microphone MEMS (3) est formé dans une premier wafer (33) et la membrane d'amortissement (11) est formée dans un second wafer (35).

11. Système (1) selon une ou plusieurs des revendications précédentes
**caractérisé en ce que**
le microphone MEMS (3) est en contact avec un support de circuit (25), de préférence une carte de circuit imprimé, dans lequel le support de circuit (25), de préférence une carte de circuit imprimé, comporte une cavité (27) destinée à recevoir le microphone MEMS (3).

12. Système (1) selon une ou plusieurs des revendications précédentes
**caractérisé en ce que**
un espace (29) entre le microphone MEMS (3), un interposeur (15) et/ou un support de circuit (25), de préférence une carte de circuit imprimé, est rempli d'un matériau de remplissage.

13. Système (1) selon la revendication précédente
**caractérisé en ce que**
le matériau de remplissage comprend un ou plusieurs polymères, de préférence un ou plusieurs polysiloxanes cycliques, linéaires, ramifiés et/ou réticulés.

14. Utilisation d'un système (1) selon une ou plusieurs des revendications précédentes pour des mesures aéroacoustiques, de préférence pour mesurer des ondes de pression acoustique sur des surfaces d'un composant de véhicule.
